(19) Europäisches Patentamt / European Patent Office / Office européen des brevets

(11) **EP 1 371 167 B1**

(12) **EUROPEAN PATENT SPECIFICATION**

(45) Date of publication and mention of the grant of the patent:
**05.03.2008 Bulletin 2008/10**

(21) Application number: **02723501.9**

(22) Date of filing: **20.03.2002**

(51) Int Cl.:
*H04L 7/00* (2006.01)    *H03L 7/087* (2006.01)
*H03L 7/197* (2006.01)    *H03L 7/089* (2006.01)
*H03L 7/091* (2006.01)    *H03L 7/095* (2006.01)

(86) International application number:
**PCT/US2002/008297**

(87) International publication number:
**WO 2002/076009 (26.09.2002 Gazette 2002/39)**

(54) **FRACTIONAL-N FREQUENCY SYNTHESIZER WITH FRACTIONAL COMPENSATION METHOD**

FRAKTIONAL-N-FREQUENZSYNTHESIZER MIT FRAKTIONAL-KOMPENSATIONSVERFAHREN

SYNTHETISEUR DE FREQUENCE N-FRACTIONNAIRE AVEC PROCEDE DE COMPENSATION FRACTIONNAIRE

(84) Designated Contracting States:
**AT BE CH CY DE DK ES FI FR GB GR IE IT LI LU MC NL PT SE TR**
Designated Extension States:
**AL LT LV MK RO SI**

(30) Priority: **20.03.2001 US 276927 P**
**20.03.2001 US 276912 P**
**29.08.2001 US 940807**
**29.08.2001 US 940808**

(43) Date of publication of application:
**17.12.2003 Bulletin 2003/51**

(73) Proprietor: **GCT Semiconductor, Inc.**
**San Jose, CA 95131 (US)**

(72) Inventors:
• **HUH, Hyungki**
**Sungdong Gu, Seoul (KR)**
• **SONG, Eunseok**
**Seoul (KR)**
• **LEE, Kang Yoon**
**Youngdeungpo Gu, Seoul (KR)**

• **KOO, Yido**
**Seocho Gu,**
**Seoul (KR)**
• **LEE, Jeongwoo**
**Seoul (KR)**
• **PARK, Joonbae**
**Seoul (KR)**
• **LEE, Kyeongho**
**Kwanak-gu**
**Seoul 151-704 (KR)**

(74) Representative: **Unwin, Stephen Geoffrey et al**
**Fry Heath & Spence LLP**
**The Gables**
**Massetts Road**
**Horley**
**Surrey RH6 7DQ (GB)**

(56) References cited:
**EP-A- 0 907 252**    **US-A- 4 868 513**
**US-A- 5 815 016**    **US-A- 5 838 205**
**US-A- 5 909 474**    **US-A- 5 953 386**
**US-B1- 6 388 536**

**Description**

## 1. Field of the Invention

The present apparatus and method can be used for any system that requires fractional resolution of a reference frequency, and relates, in particular, to a PLL-based frequency synthesizer including sample and hold type fractional-N synthesizers for use in a modern wireless or wired communication system.

## 2. Background of the Related Art

Frequency synthesizers are typically used in modern wireless communication systems to produce a desired output frequency in both the receiver and transmitter. Among the various phase locked loop (PLL) based frequency synthesizers, fractional-N frequency synthesizers are suitable for the communication systems where the channel interval is small. Fractional-N architecture allows frequency resolution that is a fractional portion of a reference frequency $F_{REF}$, and an output frequency signal $F_{OUT}$ is related to the reference frequency $F_{REF}$ by the relationship $F_{OUT}=F_{REF}(N+K/F)$, where F is the fractional resolution of the device with respect to the reference frequency. The technique of fractional-N architecture requires generating a divider that is a fractional number rather than an integer. This is performed by changing the divider in the loop dynamically between the values N and N+1. If out of F cycles, division by N+1 is done K times and by N, F-K times, then the average division ratio is N+K/F.

The advantage of the fractional-N architecture is that the reference frequency $F_{REF}$ is not restricted by the channel spacing, and loop bandwidth can be increased. Therefore, phase noise and locking time is reduced. However, the switching of the divisors causes spurious signals in the synthesized output frequency signal $F_{OUT}$. These subharmonic spurs, also referred to as fractional spurs, must be kept below some maximum acceptable limit

Related art fractional compensation circuit attempt to reduce unwanted spurious signals. For proper fractional compensation, the area of the compensation pulse must be equal to the area of the main charge pump fractional-N ripple. In one related art fractional compensation circuit, however, the amount of the compensation current is statically fixed. Therefore, the spurious signal cancellation cannot track the dynamic change of the spurious signals with time, process, and temperature.

Another related art fractional compensation circuit, typically known as a fractional-N synthesizer, controls the dividing ratio by using a sigma-delta ($\Sigma\Delta$) modulator. A modulus divider receives an output signal from the $\Sigma\Delta$ modulator. The fractional spurious frequencies or phase noise are distributed throughout the frequency spectrum by the operation of the sigma-delta modulator. However, the absolute noise level may be increased above acceptable levels. A more robust and reliable fractional compensation scheme, which does not degrade the spectral purity, is needed.

Frequency synthesizers used in modern wireless communication systems typically utilize a Phase Locked Loop (PLL). PLLs usually include a voltage controlled oscillator (VCO), phase detector (PD) and loop filter (LF). To integrate a PLL on a single integrated circuit, a large LF capacitor, which is used to stabilize the PLL, occupies most of the chip area of the circuit because the capacitance needed in the loop filter (LF) is often on the order of several micro-farads. As recent wireless systems are attempting to integrate the overall receiver and transmitter (including the PLL) on a single chip the required capacitance of the LF capacitor is a significant problem.

One related art approach to reduce the LF capacitance is to use a sample-and-hold circuit as a phase detector or comparator. The capacitor in the sample-and-hold circuit has a much smaller capacitance than that in a typical loop filter. The other advantage of a sample-and-hold phase detector is that the output contains no high frequency harmonics of the input frequency. If the phase is constant, the output voltage is also constant. Hence, the sample-and-hold PD is applicable to a frequency synthesizer.

U.S. Pat. No. 6,137,372 discloses a sample-and-hold type PLL frequency synthesizer that does not need a large LF capacitor. The 6,137,372 sample-and-hold PLL frequency synthesizer uses an integer-N architecture to generate output frequencies that are integer multiples of a reference frequency. However, in the integer-N architecture, the loop bandwidth is limited because the input reference frequency must be equal to the channel spacing. Hence, the attenuation of the close-in phase noise is also limited, because the phase noise of the oscillator is reduced only within the bandwidth of the loop. Another disadvantage of the integer-N architecture is a slow lock time since the lock time of the PLL is also dependent on the loop bandwidth.

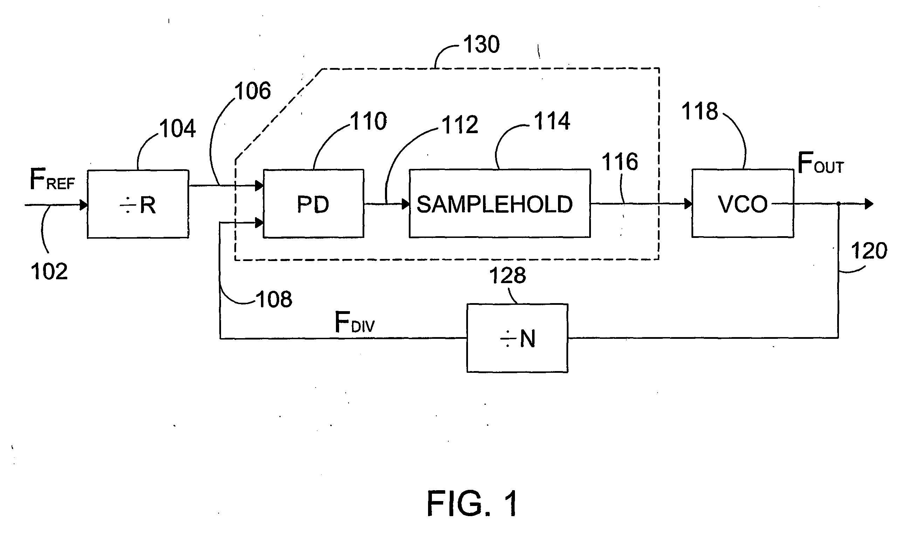

To increase the loop bandwidth, fractional-N architectures have been used for frequency synthesizers. Figure 1 illustrates a related art frequency synthesizer using a sample-and-hold circuit. As shown in Figure 1, the reference frequency divider 104 divides an input reference frequency 102 and produces a divided reference signal 106. The phase detector (PD) 110, receives the divided reference signal 106 and an output 108 of an integer divider 128 and generates an output signal 112 responsive to a comparison thereof. A sample and hold circuit 114 receives the output 112 of the PD 110. A voltage controlled oscillator 118 receives an output 116 of the sample and hold circuit 114. An output 120 of the voltage controlled oscillator 118 is an output signal $F_{OUT}$ of the frequency synthesizer circuit and is also input to the integer divider 128.

In operation, the VCO output signal 120 is divided by N in the integer divider 128 and then compared with the divided reference frequency 106 from the reference divider 104. A phase detector (PD) and the sample-and-hold circuit 130 generates a control signal that is dependent on a detected phase difference. The control signal is applied to the voltage controlled oscillator (VCO), which generates the output frequency $F_{OUT}$.

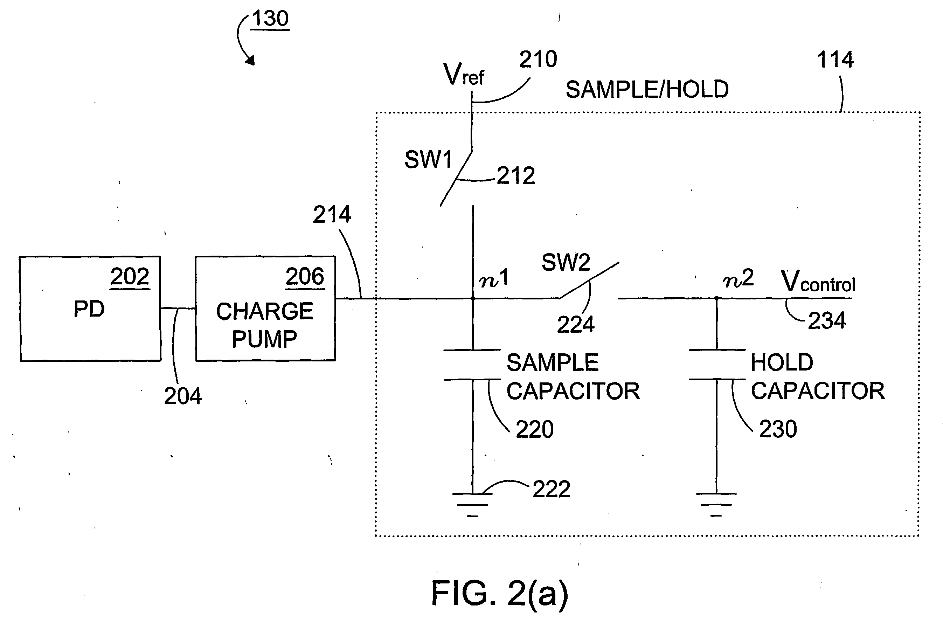

Figure 2(a) is an illustration of the related art phase detector and the sample-and-hold circuit 130. As shown in Figure 2(a), a charge pump 206 receives an output 204 of a phase detector 202. An output 214 of the charge pump 206 is received by the sample and hold circuit 114 at an input connected to a first node n1. In the sample and hold circuit 114, a reference voltage $V_{ref}$ 210 is connected to the first node n1 through a first switch 212. A sample capacitor 220 is connected between a ground reference voltage 222 and the first node n1. A second switch 224 is connected between the first node n1 and a second node n2 that is connected to an output terminal 234. A hold capacitor 230 is connected between the ground reference voltage and the second node n2. The capacitance of the sample capacitor 220 and the hold capacitor 230 is much less than that of the typical loop filter. Before phase comparison occurs in the phase detector 202, the switch SW1 is closed and the sample capacitor is charged to the reference voltage $V_{ref}$. The charge pump 206 following the phase detector 202 increases or decreases the voltage of the sample capacitor 220 from the reference voltage $V_{ref}$ according to the detected phase difference in the phase comparison. When the phase comparison is complete, the charge in the sample capacitor 220 is transferred to the hold capacitor 230 via the second switch SW2.

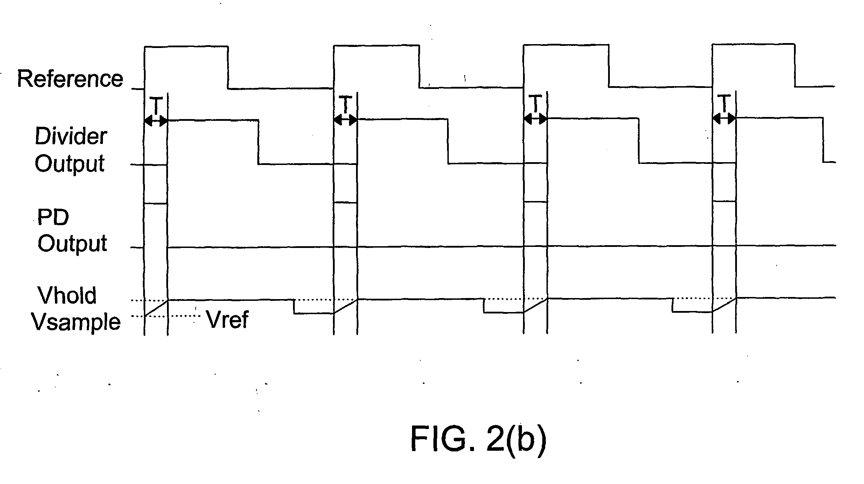

Figure 2(b) is a timing diagram of the lock state in a related art sample-and-hold type integer-N frequency synthesizer. As shown in Figure 2(b), a relationship between the reference frequency signal and the divider output (i.e., divided VCO output) exists and is a constant phase difference T when the phase is aligned in the typical loop filter type PLL. Hence, the sample-and-hold type PLL is not suitable for application as clock or data recovery where the phase must be aligned between the input reference signal and the VCO output. The phase detector output and voltage of the sample capacitor are also shown in Figure 2(b). In the integer-N frequency synthesizer, however, the phase alignment is not a requirement, and the sample-and-hold type PLL is applicable as long as the phase noise characteristic is satisfied. As shown in Figure 2(b), it is assumed that the phase of the reference frequency signal leads that of the divider output by the time T, and the phase detector generates an UP (HIGH) signal at every phase comparison to increase the voltage of the sample capacitor (Vsample) at a fixed rate from the reference voltage ($V_{ref}$). Hence, the voltage of the hold capacitor (Vhold) and the output frequency of the voltage controlled oscillator are kept constant.

As described previously, however, an integer-N frequency synthesizer has a narrower loop bandwidth than a fractional-N frequency synthesizer. To increase the loop bandwidth above the channel spacing, the fractional-N synthesizer includes a variable modulus programmable divider, which is controlled by an accumulator. The accumulator changes the division ratio of the variable modulus programmable divider regularly to generate the desired fractional division ratio. Accordingly, the control voltage of the VCO in the fractional-N frequency synthesizer is not constant, but the time-averaged value of the control voltage is meaningful. Thus, the related art fractional-N architecture cannot adopt the sample-and-hold circuit to replace the loop filter.

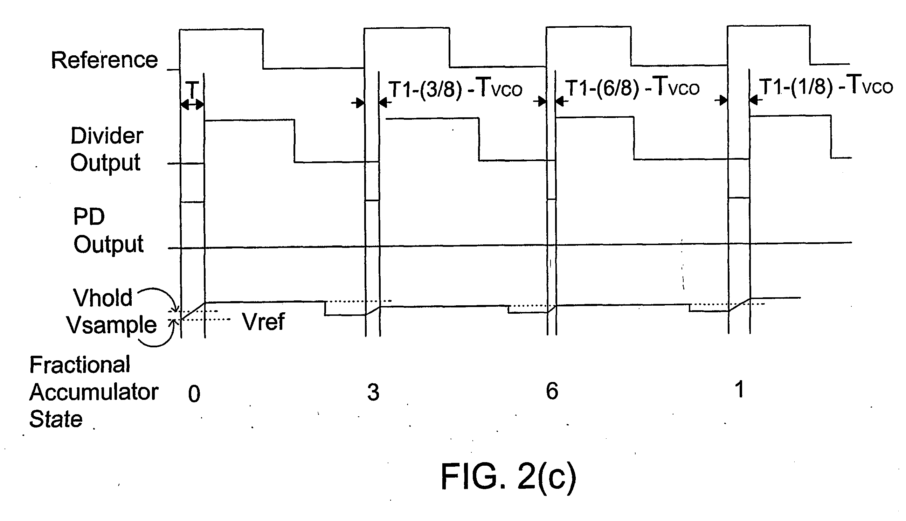

Figure2 (c) is a timing diagram that illustrates problems and disadvantages of a sample-and-hold circuit in the related art fractional-N synthesizer. As shown in Figure 2 (c), the reference frequency and the divider output do not have a constant aligned phase difference as shown in the phase detector output of Figure 2 (b). The phase detector output, the sample-and-hold circuit output voltage and the state of the fractional accumulator are also shown. In Figure 2 (c), the fractional ratio is assumed to be 3/8 (K=3, N=8) where N is the division factor. The state of the fractional accumulator varies according to the fractional ratio. Therefore, the phase of the divider output with respect to the reference frequency signal and the width of the UP pulse of the phase detector also vary. The amount of voltage change of the sample capacitor (V sample) is not fixed and the voltage of the hold capacitor (Vhold) shows fractional ripple which degrades the spectral purity of the synthesized frequency.

EP-0907252 discloses a phase-locked loop with improved trade-off between lock-up time and power dissipation and having a divider circuit in its feedback path.

The above references are incorporated by reference herein where appropriate for appropriate teachings of additional or alternative details, features and/or technical background.

## SUMMARY OF THE INVENTION

An object of the present invention is to solve at least the above problems and/or disadvantages and to provide at least the advantages described hereinafter.

Another object of the present invention is to provide a phase locked loop-based fractional-N synthesizer.

Another object of the present invention is to provide a fractional compensation circuit and method that incorporates two phase detectors.

Another object of the present invention is to incorporate fractional spur compensation circuitry that dynamically compensates fractional spurs or charge pump ripple whenever the charge pump operates.

Another object of the present invention is to provide a phase locked loop-based fractional-N synthesizer and method that uses a plurality of phase detectors to dynamically cancel spurious signals.

Another object of the present invention is to provide a phase locked loop-based fractional-N synthesizer that variously delays at least one output of a plurality of phase detectors to reduce fractional spurs.

Another object of the present invention is to provide a fractional compensation circuit that uses a charge pump stage composed of N charge pumps so that a number of the N charge pumps that operate during a phase comparison is determined by a fractional accumulator stage.

Another object of the present invention is to provide a fractional compensation circuit and method that incorporates a sample-and-hold circuit in a loop filter.

Another object of the present invention is to provide a phase locked loop-based fractional-N synthesizer and method that uses a plurality of phase detectors to dynamically cancel spurious signals and a sample-and-hold circuit.

Another object of the present invention is to provide a fractional compensation circuit that uses a charge pump stage composed of N charge pumps coupled to a sample-and-hold circuit in a loop filter so that a number of the N charge pumps that operate during a phase comparison is determined by a fractional accumulator stage.

An advantage of a fractional-N architecture and method according to the present invention is that a reference frequency is not restricted by the channel spacing and loop bandwidths can be increased.

Another advantage of a fractional-N architecture and method according to the present invention-is that subharmonic spurs or fractional spurs can be kept low.

Another advantage of a fractional-N architecture and method according to the present invention is that the spurious signal cancellation can occur dynamically.

Another advantage of a fractional-N architecture and method according to the present invention is that it avoids the need for compensation current trimming.

Another advantage of a fractional-N architecture and method according to the present invention is that it is robust to environmental changes.

Another advantage of a fractional-N architecture and method according to the present invention is that circuit size is reduced.

Another advantage of a fractional-N architecture and method according to the present invention is that it avoids the need for a large loop filter capacitor.

Another advantage of a fractional-N architecture and method according to the present invention is that a sample-and-hold circuit can be implemented in the PLL to provide a stable control voltage.

To achieve the above objects in a whole or in part and in accordance with the purpose of the present invention, as embodied and broadly described, a phase locked loop, comprising: a first phase detector that receives an input signal and a first divided signal to output a first comparison signal; a second phase detector that receives the input signal and a second divided signal to output a second comparison signal; a circuit that receives the first and second comparison signals and generates an output signal responsive to the comparison signals; a voltage-controlled oscillator that receives the output signal from the circuit and generates a prescribed frequency signal; and a programmable modulus divider that receives the prescribed frequency signal and generates the first divided signal and the second divided signal by dividing the prescribed frequency signal by one of a first value and a second value, the first and second divided signals having the same frequency and a phase difference that is a period of the prescribed frequency signal from the voltage controlled oscillator.

To further achieve the above objects in a whole or in part and in accordance with the purpose of the present invention, as embodied and broadly described, a method for generating frequency signals, comprising:

(a) dividing a frequency signal output from an oscillator to produce a first divided signal (310);

(b) dividing the frequency signal output from an oscillator to produce a second divided signal not equal to the first divided signal, the first and second divided signals generated by selectively dividing the frequency signal by one of a first value and a second value, the first and second divided signals having the same frequency and a phase difference that is a period of the frequency signal output of the oscillator;

(c) comparing the first divided signal to a reference signal to generate a first control signal;

(d) comparing the second divided signal to a reference signal to generate a second control signal; and

(e) adjusting the oscillator based on the first control signal and second control signal.

Additional advantages, objects, and features of the invention will be set forth in part in the description which follows and in part will become apparent to those having ordinary skill in the art upon examination of the following, or may be learned from practice of the invention. The objects and advantages of the invention may be realized and attained as particularly pointed out in the appended claims.

**EP 1 371 167 B1**

**BRIEF DESCRIPTION OF THE DRAWINGS**

The invention will be described in detail with reference to the following drawings in which like reference numerals refer to like elements wherein :

Figure 1 shows a related art embodiment of a Integer-N frequency synthesizer using a sample-and-hold circuit;
Figure 2 (a) shows a phase detector and a sample-and-hold circuit of Figure 1;
Figure 2 (b) shows a timing diagram of a lock state in a related art sample-and-hold type integer-N frequency synthesizer;
Figure 2 (c) shows a timing diagram of a sample-and-hold circuit in a related art fractional-N synthesizer;
Figure 3 is a schematic diagram that shows a preferred embodiment of a frequency synthesizer including a phase-locked lopp(PLL) according to the invention;
Figure 4 is a diagram that shows a preferred embodiment of a programmable modulus divider of Figure 3;
Figure 5 is a diagram that shows a phase detector circuit having a charge pump bock with a charge pump stage following phase detectors;
Figure 6 is a diagram that shows a control timing diagram of a charge pump block of Figure 5;
Figure 7 is a diagram that shows another embodiment of a phase detector circuit including a charge pump block in which a number of charge pumps is reduced to N compared to a total of 2N charge pumps in Figure 5;
Figures 8(a) and 8(b) show timing diagrams of the phase lag and lead, respectively, of a divided reference frequency and a divided VCO frequency;
Figure 9 shows a timing diagram of a compensation scheme according to a preferred embodiment of the invention;
Figure 10 is a diagram that shows- another preferred embodiment of a frequency synthesizer including a PLL with a delay in a phase detector circuit;
Figure 11 is a diagram that shows another preferred embodiment of a phase detector circuit having a delay;
Figure 12 is a timing diagram showing effects of introducing a delay in a phase detector circuit;
Figure 13 is a diagram that shows an exemplary digital control circuit where a number of delay taps switched into the circuit determines the delay;
Figure 14 is a diagram that shows an exemplary analog circuit where the control voltage controls the delay of each delay cell and the total delay of the circuit;
Figure 15 is a diagram that shows a sample-and-hold circuit where each charge pump output is coupled to one sample capacitor;
Figure 16 is a timing diagram that illustrates a preferred embodiment of a method of operating a sample-and-hold fractional-N frequency synthesizer according to the invention;
Figure 17 is a diagram that shows another preferred embodiment of a sample-and-hold type fractional-N frequency synthesizer including a detector circuit to set a reference voltage according to the present invention;
Figure 18 is a diagram that shows a portion of another preferred embodiment of a fractional-N synthesizer including a detector circuit to set a reference voltage according to the present invention; and
Figure 19 is a timing diagram that shows another preferred embodiment of a method of operating a sample-and-hold type fractional-N frequency synthesizer when the reference voltage is matched with the desired control voltage according to the present invention.

**DETAILED DESCRIPTION OF PREFERRED EMBODIMENTS**

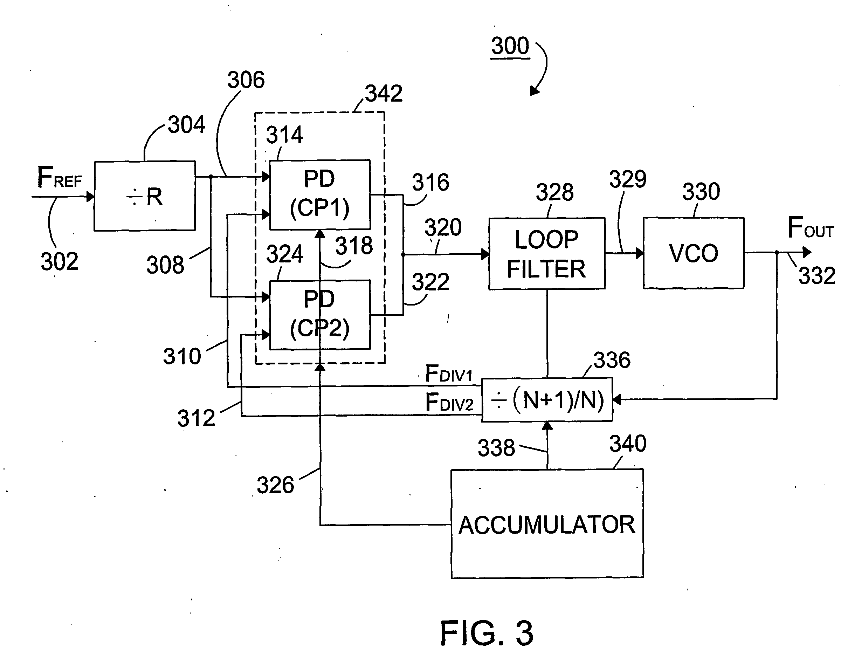

Figure 3 is a schematic diagram that shows a preferred embodiment of a fractional compensation circuit according to the present invention. As shown in Figure 3, a frequency synthesizer 300 includes a phase locked loop (PLL) having a phase detector circuit 342, a loop filter 328, a voltage controlled oscillator (VCO) 330, and a programmable modulus divider 336 coupled to an accumulator 340. In the frequency synthesizer 300, a reference frequency 302 is fed into a reference frequency divider 304. The output of the reference frequency divider 304, is branched into two phase detector feeds 306 and 308. The two phase detector feeds 306 and 308, are respectively input to phase detectors 314 and 324 of the phase detector circuit 342. Outputs 316 and 322, of the phase detectors 314 and 324, are coupled into an input 320 of the loop filter (LF) 328. An output 329 of the loop filter 328 is fed into the voltage controlled oscillator (VCO) 330. The phased detector circuit 342, contains the two phase detectors 314 and 324 that preferably contain two charge pump blocks (not shown). The terms "charge pump," "charge pump block," and "CP" refer to the same type circuit and are used interchangeably herein. Where more than one charge pump is referenced, CP1 and CP2 are sometimes used.

The modulus programmable divider 336 divides an output frequency signal $F_{OUT}$ 332 of the VCO 330, alternatively by N and N+1, respectively, depending on the control signal 338 from the accumulator 340. Each of the two divided VCO signals $F_{DIV1}$ and $F_{DIV2}$ from the modulus programmable divider serve as second inputs 310 and 312, respectively, of the phase detectors 314 and 324. The two divided VCO signals $F_{DIV1}$ and $F_{DIV2}$ 310 and 312, produced by the modulus programmable divider 336, preferably have the same frequency and a phase difference that is a period of VCO ($1/F_{OUT}$). N equal charge pumps (not shown) are preferably coupled to each phase detector 314 and 324. The accumulator 340, controls the number of charge pumps to be enabled before the phase comparison in the phase detectors 314 and 324 between the input reference frequency ($F_{REF}$) and the divided VCO clock ($F_{DIV1}$, $F_{DIV2}$) occurs. Thus, the accumulator 340 outputs enable signals 318 and 326, respectively, to the phase detectors 314 and 324.

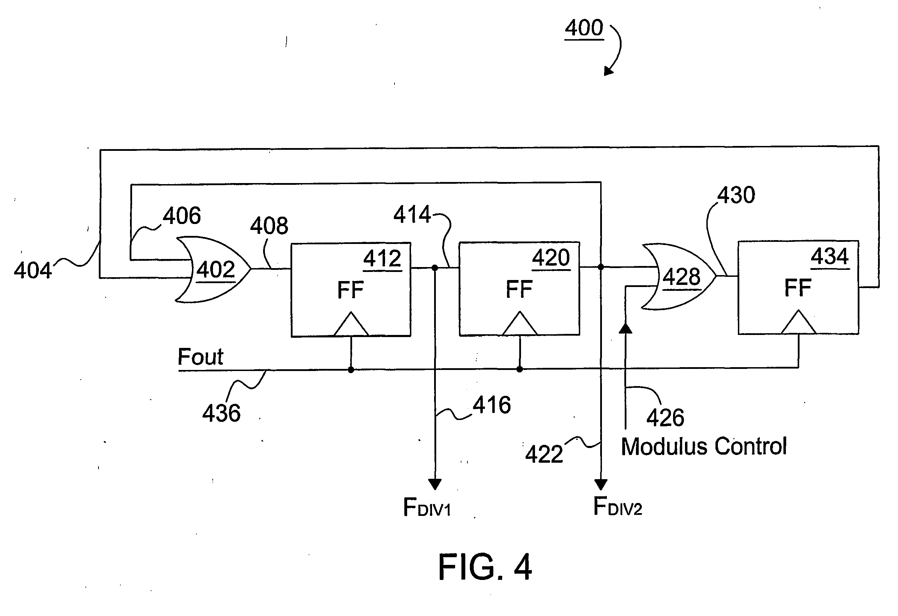

Figure 4 is a diagram that shows a preferred embodiment of a programmable modulus divider 400, (e.g., dividing an input signal by N+1 or by N, which produces two divided VCO outputs $F_{DIV1}$ and $F_{DIV2}$, 416 and 422. The programmable modulus divider 400 can be used as the programmable modulus divider 336 of Figure 3. The programmable modulus divider 400 can include three flip flops 412, 420, 434 and two logic gates 402,428. Since the three flip-flops 412, 420 and 434, are preferably clocked by an identical output signal 436, which is preferably the output frequency signal $F_{OUT}$ 336, the phase difference between $F_{DIV1}$ and $F_{DIV2}$, 416 and 422, is a period of a VCO frequency ($T_{VCO}=1/F_{OUT}$).

As shown in Figure 4, a first "OR" gate 402, receives an input 404 from the third flip-flop 434, and receives an input 406 from the second flip-flop 420. The first flip-flop 412 receives and processes an output 408 of the first "OR" gate 402 according to the $F_{OUT}$ signal 436. The second flip-flop 420 receives and processes an output 414 from the first flip-flop 412 according to the $F_{OUT}$ signal 436. In addition to the input 406 from the second flip-flop 420, the second "OR" gate 428 receives a modulus control signal as an input 426. The third flip-flop 434 receives and processes an output 430 from the second "OR" gate 428 according to the $F_{OUT}$ signal 436. The output signals 414 and 406 of the first and second flip flop 412, 420 are preferably the divided VCO signals $F_{DIV1}$ 416 and $F_{DIV2}$ 422 from the programmable modulus divider 400.

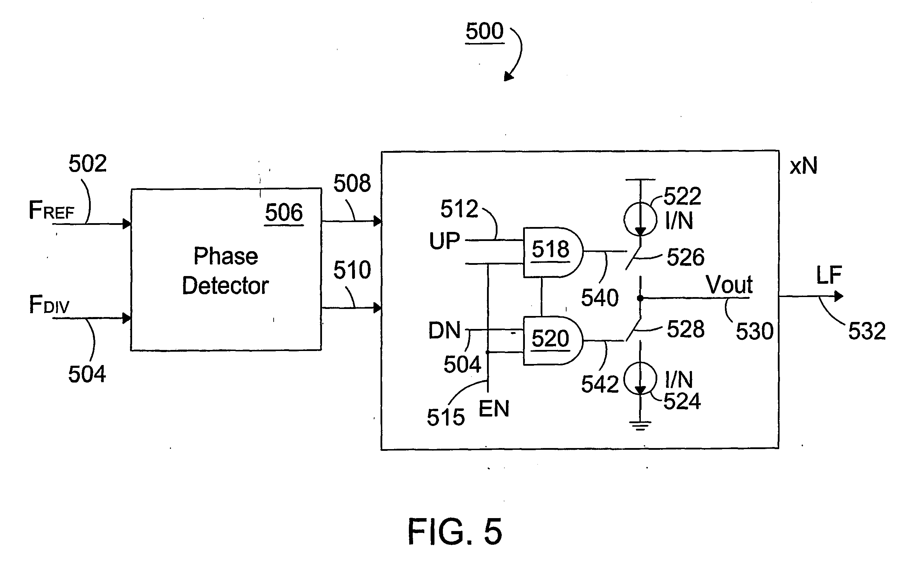

Figure 5 is a diagram that shows a preferred embodiment of a phase detector and charge pump circuit 500. As shown in Figure 5, the phase detector and charge pump circuit 500 can be used, for example, as one of the phase detectors 314, 324 in the phase detector circuit 342 shown in Figure 3. The charging or discharging current provided from each charge pump to the LF (not shown) is preferably determined as I/N, where I is the current of a typical fractional-N frequency synthesizer. An enable signal (EN) 515, is generated by the corresponding accumulator (not shown) such as the accumulator 340 according to the fractional accumulator state, and controls whether the charge pump 534 is enabled. As shown in Figure 5, there are preferably N charge pumps 534 coupled to the phase detector 506 that receive an enable signal from an accumulator.

As shown in Figure 5, a phase detector 506 compares an $F_{REF}$ input 502 as a divided reference frequency, and an $F_{DIV}$ input 504 to generate two outputs 508 and 510, each received by a charge pump circuit 534, responsive to the comparison. A first "AND" gate 518 of the charge pump 534 receives an "UP" signal 512 and the "EN" signal 515. A second "AND" gate 520, receives a "DN" signal 514, and the "EN" signal 515. Preferably, the output signal 508 is the "UP" signal 512 and the output signal 510 is the down "DN" signal 514. A first switch 526 and a first current source 522 are coupled in series between a power supply voltage and an output terminal 530. The state of the first switch 526 (e.g., open or closed) is controlled by an output signal 540 from the first "AND" gate 518 responsive to the comparison in the corresponding phase detector and the enable signal EN. A second switch 528 and a second current source 524 are coupled in series between the output terminal 530 and a ground reference voltage. The state of the second switch 528 is preferably controlled by an output signal 542 from the second "AND" gate 520. Thus, the first current source 522 and the second current source 524, are selectively coupled into the single output terminal 530 of the charge pump 534. An output 532 of the N charge pumps 534 of phase detector and charge pump circuit 500 is received by the loop filter (not shown). Output terminals 530 of the N charge pumps 534 are coupled to provide the output 532 to the loop filter. However, the present invention is not intended to be so limited.

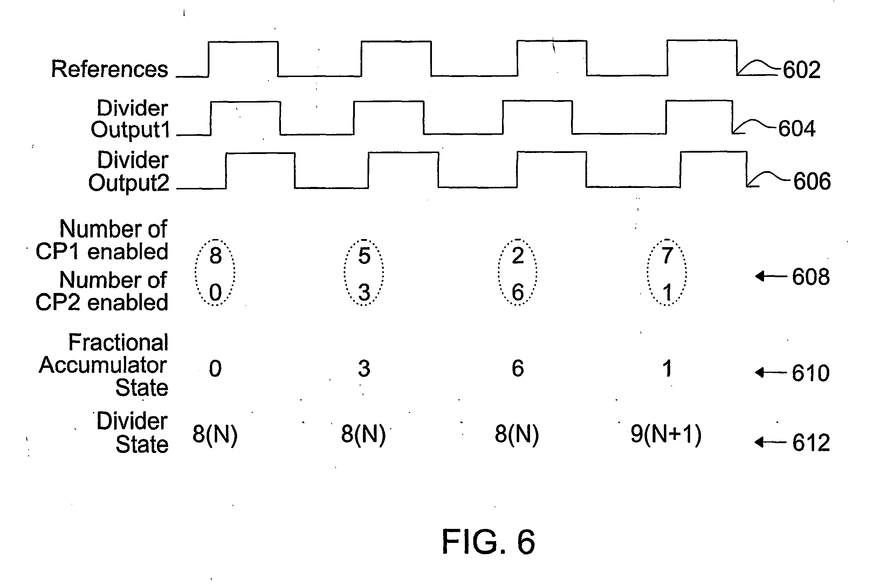

The control timing relationship of a charge pump block is described in Figure 6 where the fractional number is assumed as 3/8(K=3,N=8). Accordingly, the modulus divider divides by 8(N) 5 times and by 9(N+1) 3 times out of 8 cycles. The timing relationship shown in Figure 6 can be used for the charge pump block associated with each phase detector 314,324 of Figure 3. Thus, for example, the phase detector circuit 342 could include 2(N=8) or 16 charge pump stages 534.

The waveforms shown in Figure 6 are the divided reference frequency voltage 602, and the voltages of the outputs of the modulus programmable divider 604 and 606 (e.g., 310, 312). The number of enabled charge pumps for CP1 and CP2 (e.g., within PD 314 and PD 324) are indicated by 608, and the state of the fractional accumulator is indicated by 610. The divider state of the synthesizer is indicated by 612. As shown in Figure 6, the number of charge pumps (CP1 and CP2) enabled during the phase comparison is determined by the accumulator state 610. The total number of charge pumps enabled is always fixed as the division factor N.

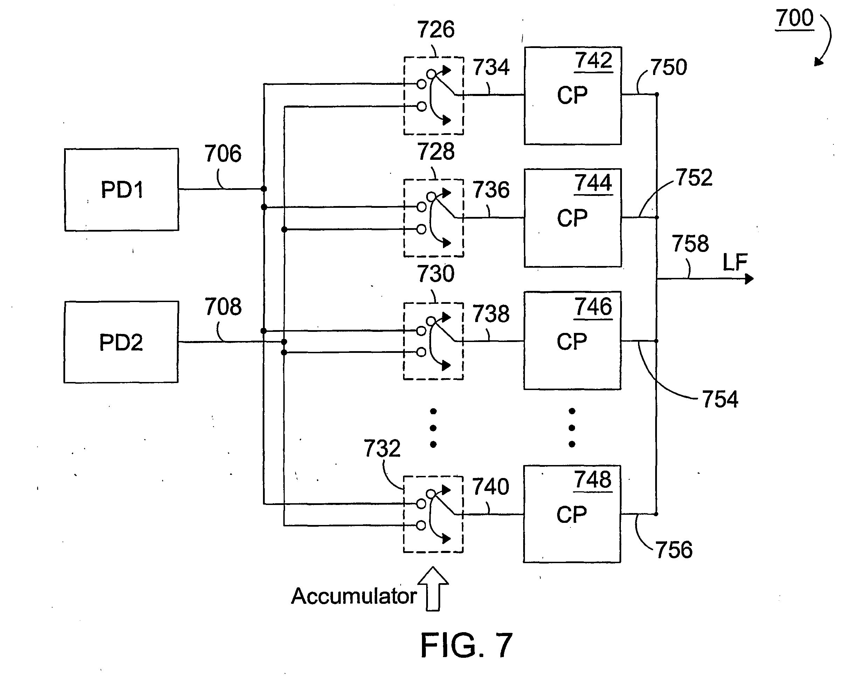

Another preferred embodiment of a phase detector circuit including a charge block pump with N charge pumps is illustrated in Figure 7. As shown in Figure 7, a charge pump block 700 receives the output 706 of the first phase detector PD1, which serves as a series of first inputs to switches 726, 728, 730, ..., 732, respectively. The output 708 of the second phase detector PD2 serves as a series of second inputs to the switches 726, 728, 730, ..., 732, respectively. Respective switch outputs 734, 736, 738 ..., 740, of the switches 726, 728, 730 and 732 serve as inputs to the charge pumps 742, 744, 746 ..., 748. Outputs 750, 752, 754, ..., 756 of the preferably N charge pumps 742, 744, 746 ..., 748, are coupled into an output signal 758 to be connected to the loop filter (not shown). In the charge pump block 700, the number of charge pumps is reduced to N, compared to a total of 2N charge pumps of Figure 5, when the accumulator controls the connection of the phase detectors PD1 and PD2 to the charge pumps 726, 728, 730,..., 732, as shown in Figure 7.

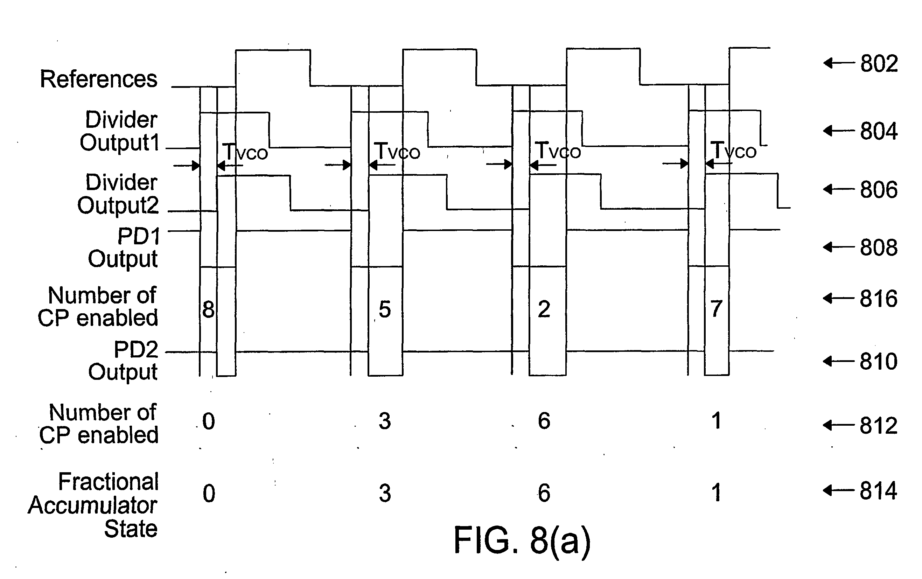

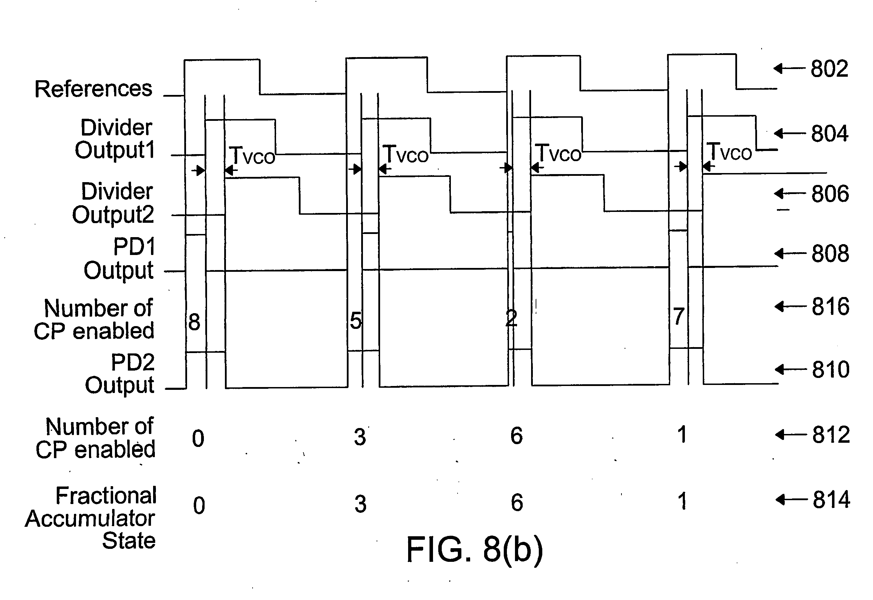

The phase relationship between a divided reference frequency and a divided VCO frequency is shown in Figures 8(a) and 8(b). Figure 8(a) illustrates a relative phase lag of the divided reference signal, and Figure 8(b) shows a relative phase lead of the divided reference signal. For example, Figures 8(a) and 8(b) can show a phase relationship between the divided reference frequency 306 and the divided VCO frequencies 310, 312 of the frequency synthesizer 300 of Figure 3. As shown in Figures 8(a) and 8(b), the relative voltage waveforms include the reference frequency 802, the Divider Output$_1$ 804, the Divider Output$_2$ 806, the PD1 output 808, and the PD2 output 810. The number of enabled charge pumps 812 and 816, which is always the division factor N, and the fractional accumulator state 814, are also indicated relative to the waveforms.

In Figure 8(a), both outputs 808 and 810 of the phase detectors, in response to a phase lag of the divided reference frequency ($F_{REF}$) 802, cause all charge pumps to discharge (e.g., generate a "DOWN" signal) the loop filter to decrease the VCO output frequency. Conversely, in Figure 8(b) a phase lead of the divided reference frequency causes both the outputs 808 and 810 of the phase detectors discharge all the charge pumps (e.g., generate the "UP" signal) and causes the VCO to increase its output frequency. In a locking state, the phase of the divided reference frequency ($F_{REF}$) 802, is laid between two divided VCO frequencies $F_{DIV1}$ and $F_{DIV2}$, 804 and 806, which means that one phase detector (PD1) generates a "DOWN" signal and the other (PD2) generates an "UP" signal. Thus, in the locking state, charge pumps connected to PD1 discharge the loop filter and charge pumps connected to PD2 charge the loop filter to preferably keep the loop filter voltage constant.

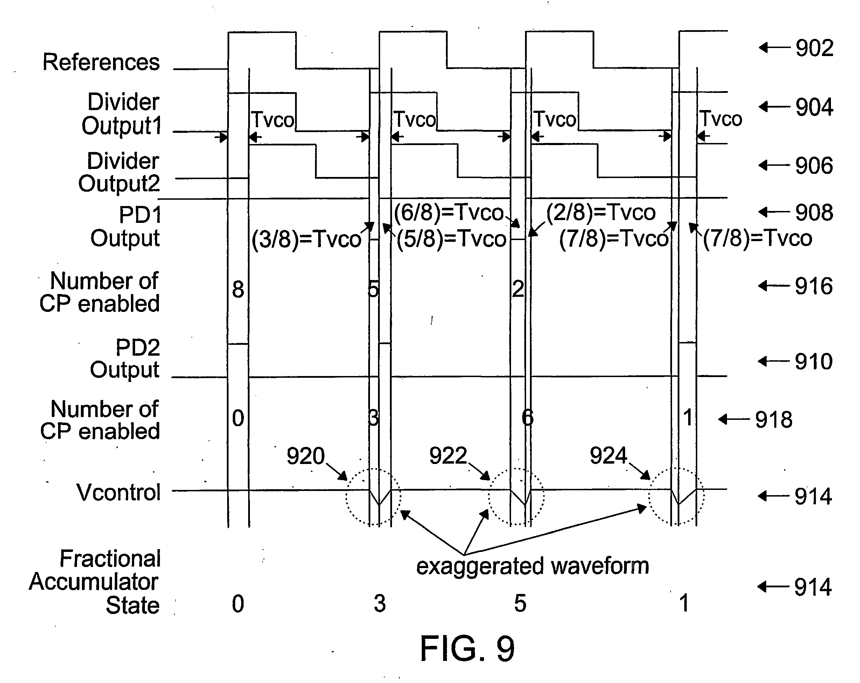

Figure 9 is a timing diagram that shows fractional compensation according to a preferred embodiment of the present invention. For example, Figure 9 can show can show a phase relationship between the divided reference frequency 306 and the divided VCO frequencies 310, 312 of the frequency synthesizer 300 of Figure 3. In Figure 9, it is assumed that the fractional number is 3/8 (K=3, N=8) as described above in Figure 6. As shown in Figure 9, the relative voltage waveforms of the divided reference frequency 902, the Divider Output$_1$ 904, the Divider Output$_2$ 906, the PD1 output 908, the PD2 output 910, and the control voltage 918 are shown. Sections of the amplitude 920, 922 and 924 of the control voltage 918 are magnified for clarity in Figure 9. The number of enabled charge pumps 912 and 916, and the fractional accumulator state 914, are also indicated relative to the waveforms.

In a locked state of a frequency synthesizer as shown in Figure 9, the charge pumps (CP1) connected to PD1 always sink current from the loop filter while those (CP2) connected to PD2 always source current to the loop filter. The amount of discharging current by the CP1 is given by the equation:

$$Q_{discharge} = I_{discharge} * T_{discharge} = \{(N-K)*(I/N)\} * \{(K/N)*T_{VCO}\} \qquad (Eq.\ 1)$$

where K represents the accumulator state. Similar to Eq.1, the amount of charging current by the CP2 is given by the equation:

$$Q_{charge} = I_{charge} * T_{charge} = \{K*(I/N)\} * [\{(N-K)/N\}*T_{VCO}] \qquad (Eq.\ 2)$$

From (Eq. 1) and (Eq. 2), $Q_{charge}$ and $Q_{discharge}$ are always the same. Accordingly, the charging current and the discharging current compensate each other to keep the loop filter output voltage constant in the locked state. The loop characteristic of the PLL preferably keeps the phase relationship to satisfy the above equations and the loop filter voltage is preferably kept constant irrespective of environmental changes such as temperature. Hence, the fractional spur is compensated dynamically. Further, no compensation current trimming is required. Further, the small perturbation of loop filter voltage during phase comparison in Figure 9 shows negligible fractional spur and phase noise compared to the related art fractional-N architecture because it does not change the average level of the control voltage and it occurs during a very short time of a period of VCO frequency.

However, preferred embodiments according to the present invention are not restricted to the above case or intended to be so limited. For example, by changing the phase difference between the divided signals and number of charge pumps used, other combinations to implement the fractional compensation of a reference signal according to the invention are possible.

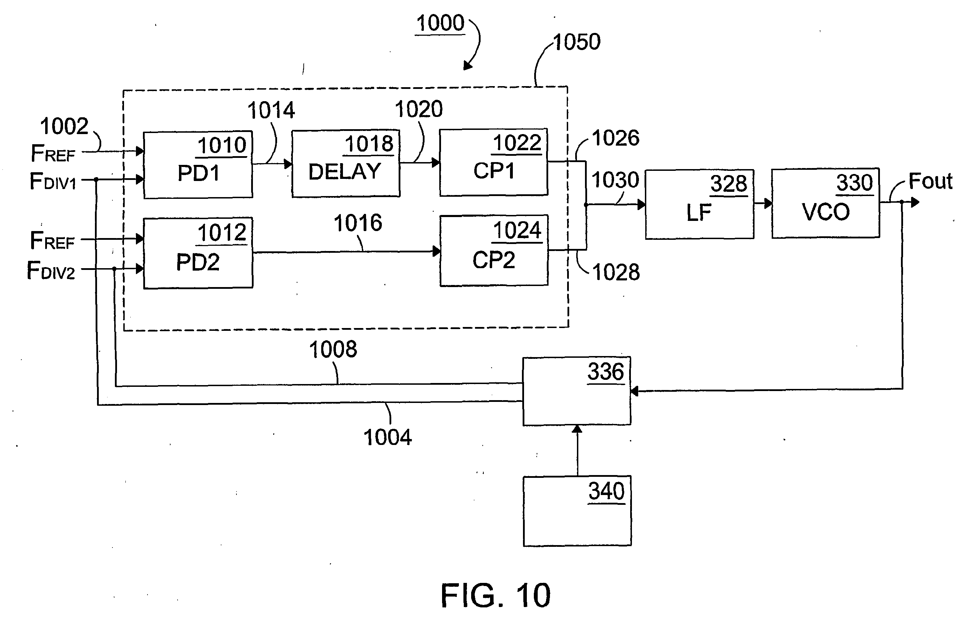

Another embodiment of a frequency synthesizer including a phase locked loop according to the present invention is illustrated in Figure 10. As shown in Figure 10, a frequency synthesizer 1000 receives a reference frequency 1002 that is input to a first and second phase detector 1010 and 1012, respectively. The first phase detector 1010 also receives a first divided VCO frequency 1004, and the second phase detector 1012 also receives a second divided VCO frequency 1008. The delay 1018 receives an output 1014 of the first phase detector 1010 and preferably outputs the same after a prescribed delay. The first charge pump 1022 receives an output 1020 of the delay block 1018, and the second charge pump 1024 directly receives the output 1016 of the second phase detector 1012. The output 1026 of the first charge pump 1022 and the output 1028 of the second charge pump 1024 are coupled together and serve as the input 1030 to a loop filter such as the loop filter 328. Preferably, the VCO 330, the modulus programmable divider 336 and the accumulator 340 are coupled to the loop filter 328 and a phase detector circuit 1050. In the preferred embodiment of Figure 10, by introducing a delay to the output of one of the first and second phase detectors 1010 and 1012, the perturbation in the loop filter voltage 1030 is further reduced. As shown in Figure 10, the output 1014 of the first phase detector 1010 is delayed to reduce or minimize the perturbation of the loop filter voltage. However, the present invention is not intended to be so limited.

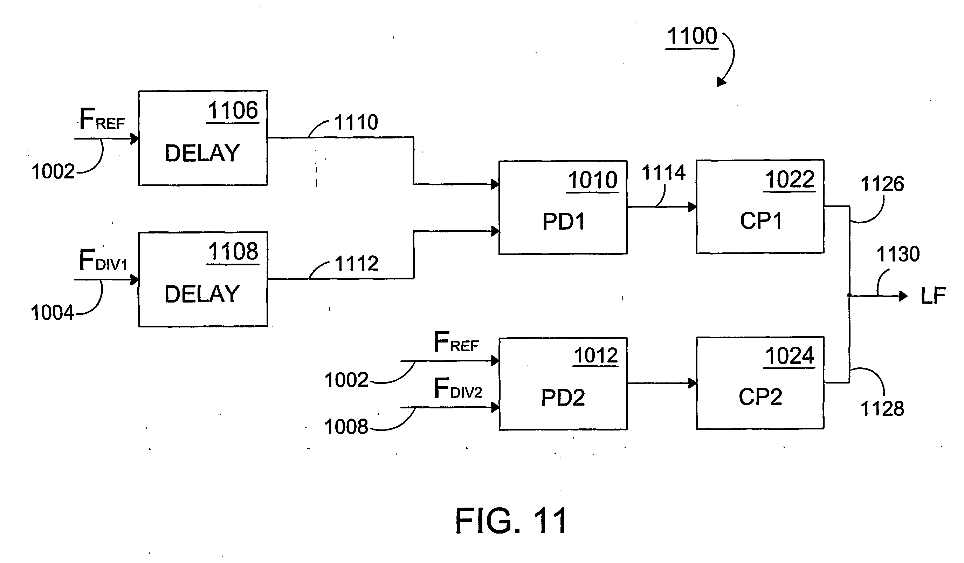

For example, the delay block 1018 as shown in Figure 10 may be placed in front of the first phase detector 1010 to preferably achieve the same effect described above. As shown in Figure 11, another preferred embodiment of a phase detector circuit 1100 for a frequency synthesizer includes a first delay block 1106 that receives the reference frequency input 1002 and a second delay block 1108 that receives the first divided VCO frequency 1004. The first phase detector 1010, receives and processes an output 1110 of the first delay block 1106 and an output 1112 of the second delay block 1108. The second phase detector 1012 and the second charge pump 1024 operate as described above. However, the first charge pump 1022 directly receives an output 1114 from the first phase detector 1010. An output 1126 from the first charge pump 1022 and an output 1128 from the second charge pump 1024 are combined and serve as the input 1130, to the loop filter (not shown).

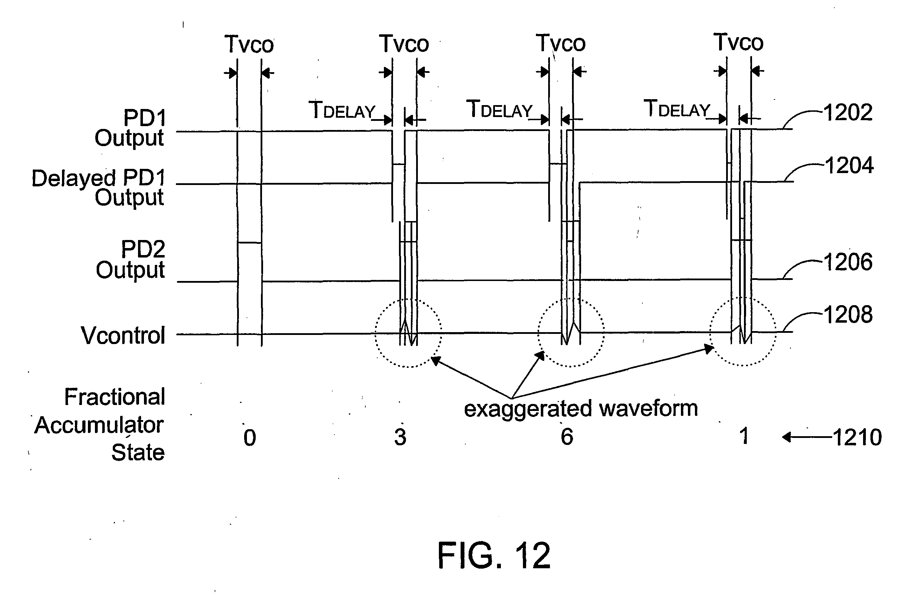

Operations and effects of delays such as generated in the preferred embodiments shown in Figures 10-11 will now be described. As shown in Figure 12, the voltage output of a first phase detector is represented by the waveform 1202, a delayed output of the first phase detector is represented by the waveform 1204, and an output of a second phase detector is represented by the waveform 1206. A voltage control signal is represented by the waveform 1208, where an illustrated amplitude is exaggerated for clarity in sections 1212, 1214, and 1216. Further, a state of a fractional accumulator is indicated by 1210.

As shown in Figure 12, the "DOWN" signal of PD1 and the "UP" signal of PD2 are overlapped. Hence, the charging current and the discharging current are simultaneously applied to the loop filter and compensate each other to reduce or minimize a peak-to-peak variation of the loop filter voltage. As long as the delayed PD1 signal 1204 and PD2 signal 1206 overlap, operations of the preferred embodiments of Figures 10-11 are effective to reduce the loop filter voltage. However, preferred embodiments of the present invention are not intended to be so limited. For example, the delay could be accomplished in the PD2 signal or both PD1 and PD2 signals. Further, an optimum or prescribed delay according to the division ratio can be set, for example, by the controlling accumulator.

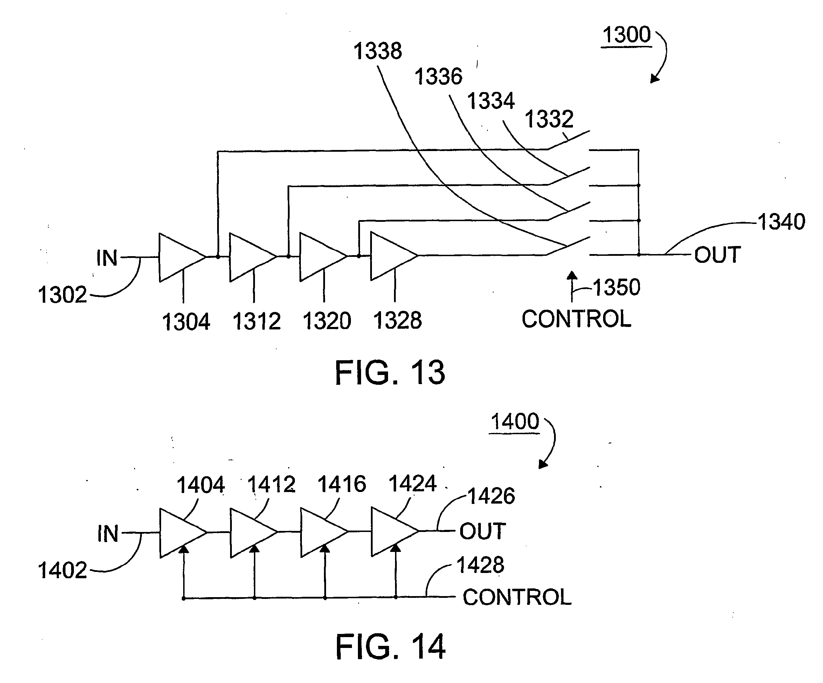

Figures 13 and 14 are diagrams that show exemplary delay control circuits. Figure 13 shows a digital control circuit 1300, where series coupled delay taps 1304, 1312, 1320, and 1328 are coupled between an input terminal 1302 and an output terminal 1340. A number of the delay taps 1304, 1312, 1320 and 1328 that are switched into the circuit determines a prescribed delay between an input signal IN and an output signal OUT. The digital delay control circuit 1300, receives the signal to be delayed as the input signal IN at the input terminal 1302. The delay taps can be, for example, an inverter. A plurality of switches 1332, 1334, 1336, 1338 are respectively connected between outputs of the delay taps 1304, 1312, 1320 and 1328 and the output terminal 1340. On/off states of the switches 1332, 1334, 1336, and 1338, are preferably determined by the control signal 1350. Thus, a total delay of the digital delay control circuit 1300 is controlled by the state of the switches 1332, 1334, 1336, and 1338.

Figure 14 shows an analog delay control circuit where a control voltage controls the delay of each delay cell and thereby a total delay of the circuit As shown in Figure 14, an analog delay control circuit 1400, receives an input signal IN at an input terminal 1402 coupled to a first delay cell 1404. Delay cells 1412, 1416 and 1422 are connected in series between the first delay cell 1404 and an output terminal 1426. The delay cells 1404,1412, 1416 and 1422 each receive a control voltage CONTROL 1428, which determines a delay generated by each of the delay cells, and thus, the control voltage 1428 determines a cumulative prescribed delay between the input signal IN and the output signal OUT. As described above, more or less delay taps or delay cells can constitute the exemplary delay circuits.

As described above, preferred embodiments of a frequency synthesizer have various advantages. A frequency synthesizer including a phase-locked loop (PLL) according to the preferred embodiments incorporates fractional spur compensation circuitry to dynamically compensate charge pump ripple whenever a charge pump operates. In the preferred embodiments, a programmable divider produces two output signals that are preferably divided signals from a voltage controlled oscillator (VCO) with the same division ratio for input to two phase detectors of the PLL. Thus, a phase difference of the divided VCO signals is preferably a period of the VCO output. In a locked state of a frequency synthesizer, the phase of the corresponding reference signals occurs between these divider signals. In a preferred embodiment, two phase detectors (PD) are used each having an input terminal connected to receive one of the two divided VCO signals of the divider. A second input terminal of each phase detector is connected to receive a reference signal. Therefore, one PD produces an "UP" signal and the other a "DOWN" signal in the locking stage.

A charge pump block can include N equal charge pump stages and is connected to each phase detector output terminal. The output terminal of each charge pump is combined in the loop filter. The number of charge pumps which operate during a phase comparison is determined by a fractional accumulator stage. In the locking state, the amount of charging current and discharging current is always the same and compensate each other. Hence, no fractional ripple occurs. Thus, preferred embodiments according to the present invention avoids or reduce the need for compensation current trimming. Fractional compensation is dynamic, and is robust to the environmental changes such as circuit age, process and temperature. Thus, preferred embodiments of a frequency synthesizer can be implemented by changing the phase difference of the divided signals of the programmable divider and the number of charge pumps activated.

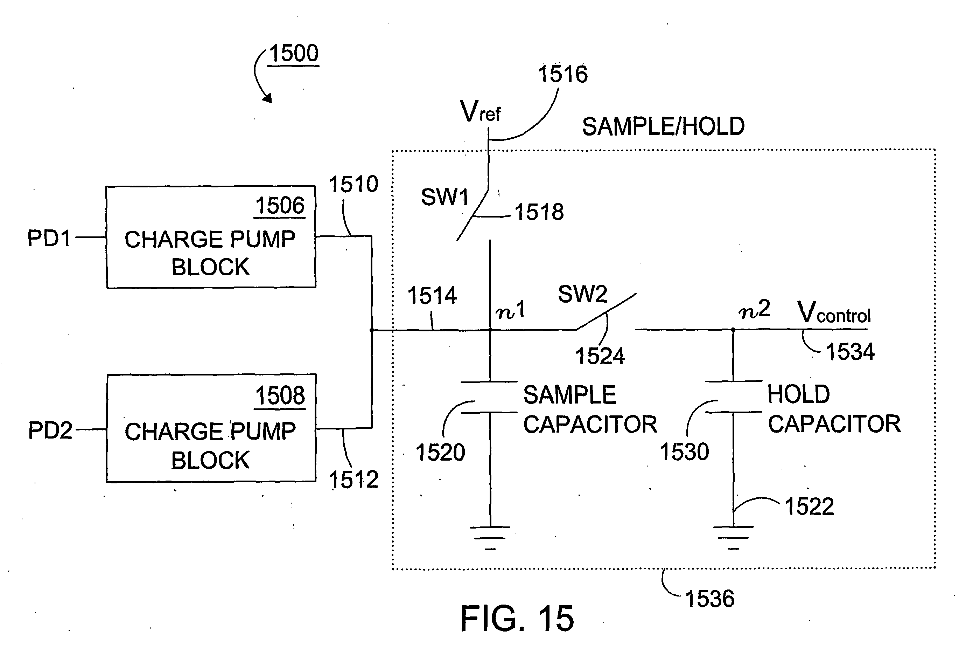

Figure 15 is a diagram that illustrates a preferred embodiment of a sample-and-hold circuit 1500 where a plurality of phase detectors are respectively coupled to one sample capacitor. As shown in Figure 15, a first charge pump 1506 receives an input from a first phase detector PD1, and a second charge pump 1508 receives an input from a second phase detector PD2. An output 1510 of the first charge pump 1506 and an output 1512 of the second charge pump 1508 are coupled together to an input 1514 of a sample-and-hold circuit 1536 that is coupled to a first node n1. In the sample and hold circuit 1536, a reference voltage $V_{ref}$ 1516 is coupled to the first node n1 through a first switch 1518. A first capacitor 1520, a sample capacitor, is coupled between a ground reference voltage 1522 and the first node n1. A second switch 1524 is coupled between the first node n1 and a second node n2 that is coupled to an output terminal 1534. A second capacitor 1530, a hold capacitor, is coupled between the ground reference voltage 1522 and the second node n2. The capacitance of the sample capacitor 1520 and the hold capacitor 1530 is much less than that of the typical loop filter capacitor. Before phase comparison occurs in the phase detectors PD1 and PD2, the first switch 1518 is closed and the sample capacitor 1520 is charged to the reference voltage $V_{ref}$ 1516. The charge pump blocks 1506 and 1508 respectively following the phase detectors PD1 and PD2 increase or decrease the voltage of the sample capacitor 1520 from the reference voltage $V_{ref}$ 1516 according to the detected phase difference in the phase comparison. When the phase comparison is complete, the charge in the sample capacitor 1520 is preferably transferred to the hold capacitor 1530 via the second switch 1524.

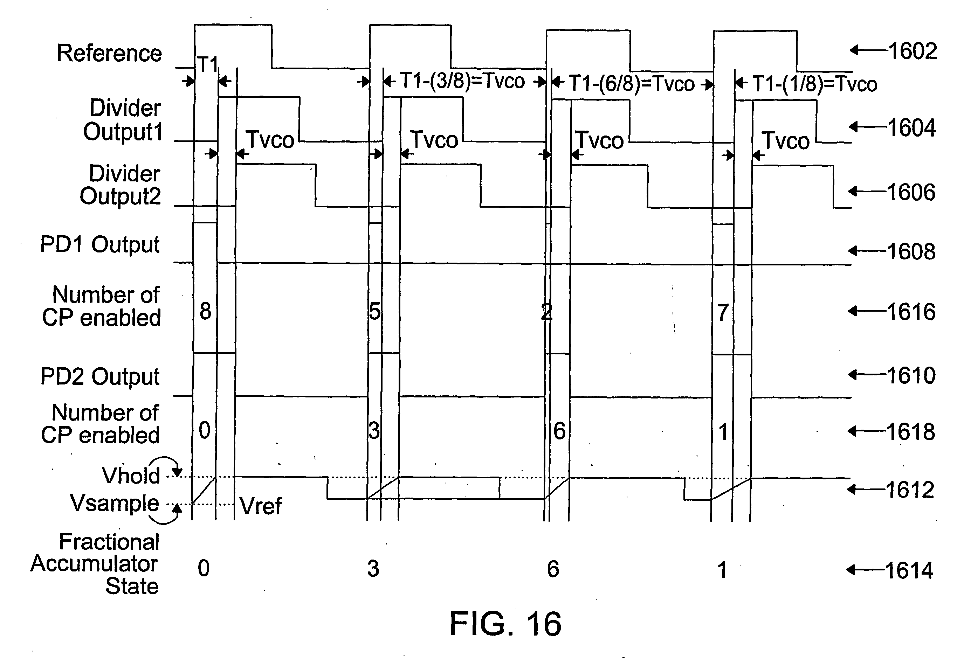

Figure 16 is a timing diagram that shows fractional compensation method of a sample-and-hold type fractional-N frequency synthesizer according to the present invention. For example, Figure 16 can show can show a phase relationship between the divided reference frequency 306 and the divided VCO frequencies 310, 312 of the frequency synthesizer 300 of Figure 3 having a sample-and-hold circuit replace the lo. In Figure 16, it is assumed that the fractional number is 3/8 (K=3, N=8). The fractional accumulator state K determines the number of charge pumps that operate during the phase comparison. For example, (N-K) charge pumps of PD1 and K charge pumps of PD2 are enabled. The total number of charge pumps enabled is always N. In Figure 16, the relative voltage waveforms of the divided reference frequency 1602, the Divider Output1 1604, the Divider Output2 1606, the PD1 output 1608, the PD2 output 1610, and the control voltage 1612 are shown. The number of enabled charge pumps 1616 and 1618, and the fractional accumulator state 1614, are also indicated relative to the waveforms. In Figure 16, a phase lead of the divided reference signal 1602 is uniformly compensated by varying the number of enabled charge pumps corresponding to PD1 and PD2 so that charging increases from PD1 and PD2 to the control voltage (Vhold) from the reference voltage (Vsample) combine to a consistent value.

As described above with respect to Figure 7, a total of N charge pumps are implemented and a switch controlled by an accumulator preferably determines the number of charge pumps connected to PD1 and PD2. As shown in Figure 16, an amount of charge sourced from the charge pump at every phase comparison is given by the equation:

$$Q_{TOTAL} = I_{CP1}*T_{CP1} + I_{CP2}*T_{CP2}$$

$$= [\{(N-K)*(I/N)\}*\{T1-(K/N)*T_{VCO}\}] + [K*(I/N)*\{(T_1-(K/N)*T_{VCO}) + T_{VCO}\}]$$

$$= I*T_1 = constant \hspace{3cm} (Eq.\ 3)$$

Therefore, the voltage change of the control voltage or the sample capacitor is constant and the voltage of the hold capacitor is also kept constant. Consequently, the synthesized output shows a good spectral purity. If the division ratio changes to generate a different frequency, the phase difference $T_1$ between the reference signal and the divided output changes, which determines the control voltage. Further, as shown in Figure 16, the reference signal leads the divided signals 1604 and 1606. However, the present invention is not intended to be so limited. If the phase of the reference signal lags that of the divided output, the voltage of the sample capacitor can be lowered from the reference voltage $V_{ref}$. In addition, preferred embodiments according to the present invention can be implemented in a variety of manners by changing the phase difference of the two divider output signals and the number of charge pumps in each phase detector.

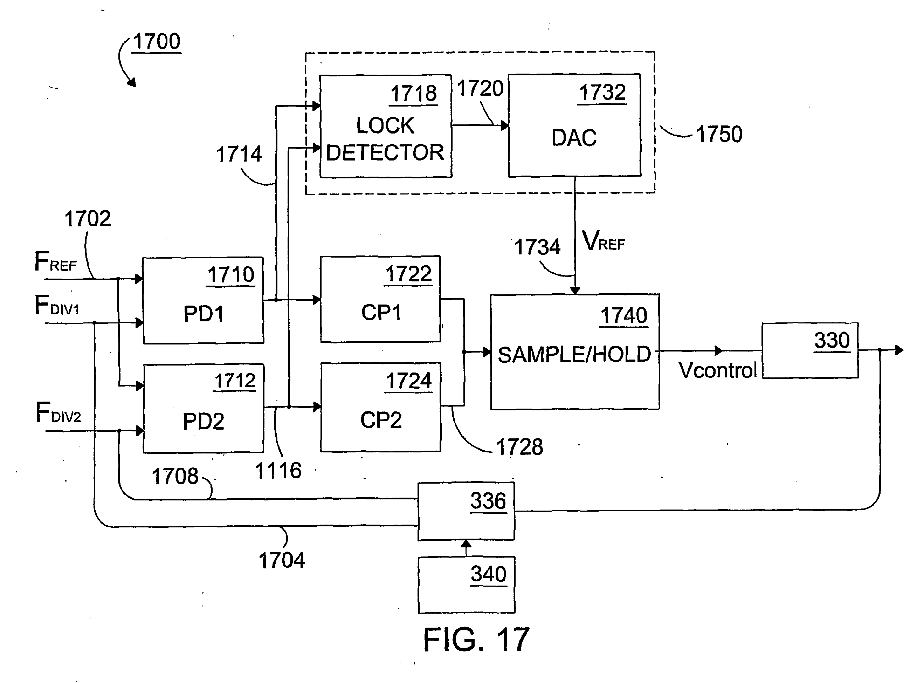

Another embodiment of a sample-and-hold type fraction-N frequency synthesizer including a phase locked loop according to the present invention is illustrated in Figure 17. As shown in Figure 17, a frequency synthesizer 1700 receives a reference frequency 1702 that is input to a first and second phase detector 1710 and 1712, respectively. The first phase detector 1710 also receives a first divided VCO frequency 1704, and the second phase detector 1712 also receives a second divided VCO frequency 1708. A lock detector 1718 and a first charge pump block 1722 receives an output 1714 of the first phase detector 1710. The lock detector 1718 and a second charge pump 1724 receive an output 1716 of the second phase detector 1712. An output 1726 of the first charge pump 1722 and an output 1728 of the second charge pump 1724 are coupled together and serve as an input 1730 to a sample-and-hold circuit 1740 such as the sample-and-hold circuit 1536. Preferably, the VCO 330, the modulus programmable divider 336 and the accumulator 340 or the like are coupled to the sample-and-hold circuit 1740 and the phase detectors 1710 and 1712.

In the preferred embodiment of Figure 17, a Digital to Analog Converter (DAC) 1732 receives an input 1720 from the lock detector 1718, and produces an output 1734 received by the sample-and-hold circuit 1740. Preferably, the output 1734 is a reference voltage $V_{ref}$ used to initialize the sample capacitor.

In a sample-and-hold type PLL, if the reference voltage is initially set too far from the locking control voltage, the loop may not generate the desired frequency. The frequency synthesizer 1700 according to the present invention includes a lock detector so that the loop will generate the desired frequency even when the reference voltage is initially set too far from the locking control voltage. As shown in Figure 17, a detector circuit 1750 can include the lock detector 1718 and the DAC 1732. The lock detector 1718 respectively preferably monitors the output of each phase detector 1710 and 1712. For example, when both outputs of PD1 and PD2 are increase voltage signals (e.g., "UP" signals), the reference signal 1702 leads the divided signals 1704 and 1708. In this case, the DAC 1732 increases the reference voltage 1734 (e.g., $V_{ref}$) to minimize the voltage difference between the reference voltage and the desired voltage. When both outputs of PD1 and PD2 are decrease voltage signals (e.g., "DOWN" signals), the reference signal 1702 is lagging the divided signals 1704 and 1708. In this case, the DAC 1732 decreases the reference voltage 1734. In the case where one phase detector generates an increase signal and another phase detector generates a decrease signal (e.g., where PD1 generates a DOWN signal and PD2 generates an UP signal), the reference voltage 1734 is very close to the desired control voltage. However, the present invention is not intended to be so limited.

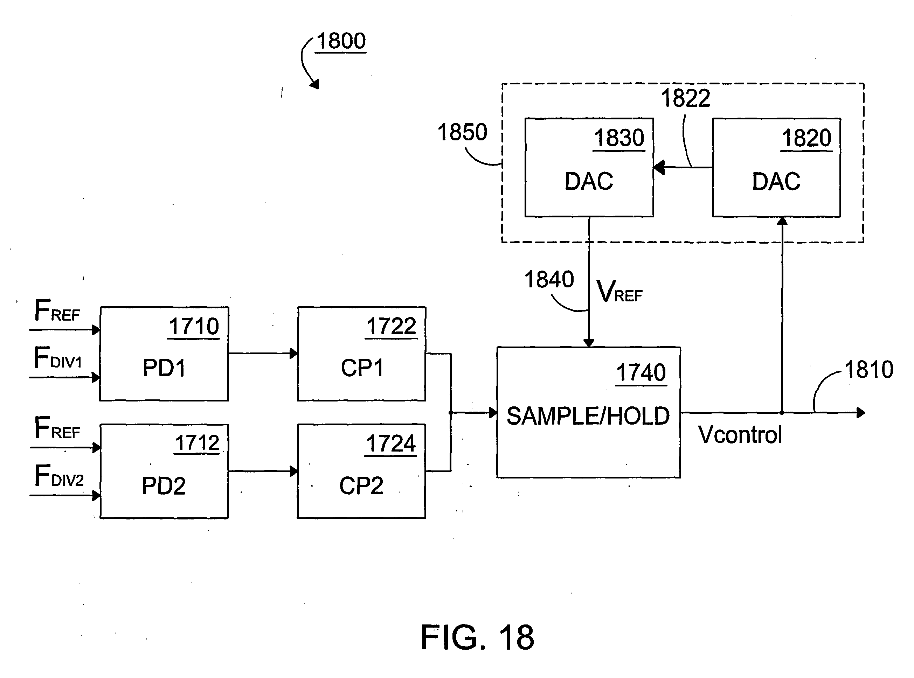

Figure 18 illustrates a system for setting the reference voltage according to another embodiment of the invention. As shown in Figure 18, another preferred embodiment of a detector circuit 1850 includes an analog-to-digital circuit (ADC) 1820 and a digital-to-analog circuit (DAC) 1830. The first phase detector 1710, the second phase detector 1712, the first charge pump 1722, the second charge pump 1724 and the sample-and-hold circuit 1740 are described above. Accordingly, a description is omitted here. An output 1810 of the sample and hold circuit 1740, is transmitted to a VCO (not shown) and to the analog to digital converter 1820. An output 1822 of the analog to digital converter 1820 is received by the digital to analog converter 1830. The ADC 1820 determines the control voltage for comparison to a prescribed voltage and preferably sets the reference voltage 1840 (e.g., $V_{ref}$) through the DAC 1830. However, the present invention is not intended to be so limited. For example, the detector circuit 1850 can also be replaced with the detector circuit 1750 where the DAC 1732 output is controlled until it is comparable to a prescribed control voltage using the lock detector 1718 that receives the output voltage 1810 from the sample-and-hold circuit 1740.

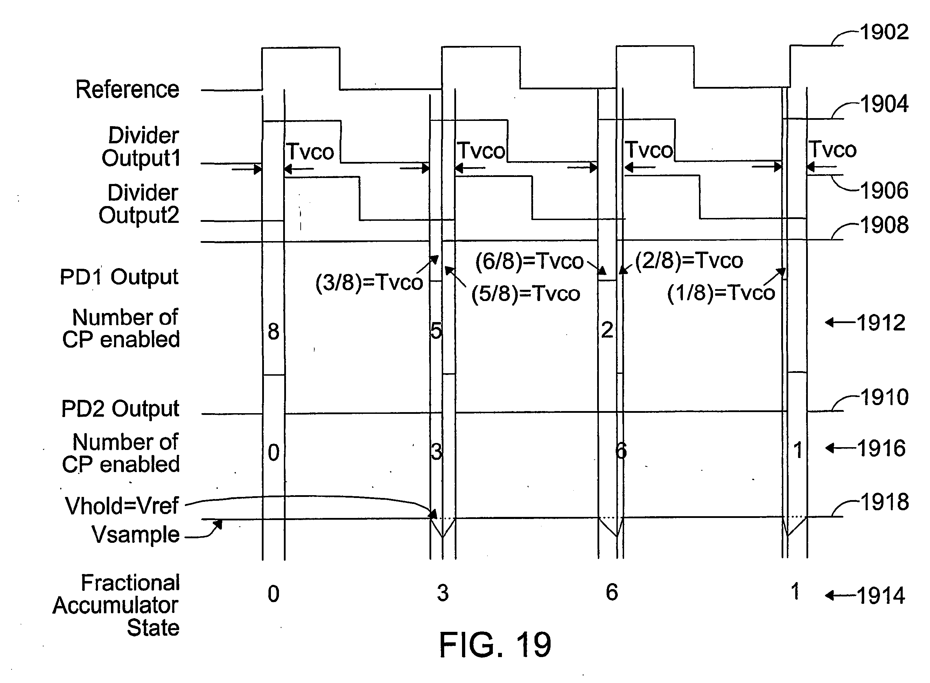

Figure 19 illustrates a timing diagram that shows fractional compensation method of a sample-and-hold type fractional-N frequency synthesizer when the reference voltage in the sample-and-hold circuit is matched with the desired control voltage. For example, Figure 19 can show can show a phase relationship between the divided reference frequency 306 and the divided VCO frequencies 310, 312 of the frequency synthesizer 300 of Figure 3. In Figure 19, it is assumed that the fractional number is 3/8 (K=3, N=8) as described above. The relative voltage waveforms are the divided reference frequency 1902, the Divider Output1 1904, the Divider Output2 1906, the PD1 output 1908, the PD2 output 1910, and the control voltage 1918 are shown. The number of enabled charge pumps 1912 and 1916, and the fractional accumulator state 1614, are also indicated relative to the waveforms.

As shown in Figure 19, the reference signal is between the divided signals. Thus, the charge pumps (CP1) coupled to PD1 always sink current from the sample-and-hold circuit while those (CP2) coupled to PD2 always source current to the sample-and-hold circuit of the frequency synthesizer. The amount of charging and discharging is accurately matched through Equation 3 and the control voltage is kept constant. According to Equation 3, the amount of discharging current by the CP1 is given by the equation:

$$Q_{discharge} = I_{discharge} * T_{discharge} = \{(N-K)*(I/N)\} * \{(K/N)*T_{VCO}\} \qquad (Eq.\ 1)$$

where K represents the accumulator state. Similar to Eq. 1, the amount of charging current by the CP2 is given by the equation:

$$Q_{charge} = I_{charge} * T_{charge} = \{K*(I/N)\} * [\{(N-K)/N\}*T_{VCO}] \qquad (Eq.\ 2)$$

From (Eq. 1) and (Eq. 2), $Q_{charge}$ and $Q_{discharge}$ are always the same.

As described above, preferred embodiments of a frequency synthesizer according to the present invention have various advantages. Preferred embodiments of a phase-locked loop (PLL) frequency synthesizer incorporate a sample-and-hold circuit in a fractional-N type synthesizer. The preferred embodiments reduce a circuit size and power requirements because a sample-and-hold circuit replaces a related art loop-filter capacitor in a fractional-N type frequency synthesizer. A frequency synthesizer including a phase-locked loop (PLL) according to the preferred embodiments also incorporates fractional spur compensation circuitry to dynamically compensate charge pump ripple whenever a charge pump operates. In the preferred embodiments, a programmable divider produces two output signals that are preferably divided signals from a voltage controlled oscillator (VCO) with a phase difference being a period of the VCO output. In a locked state of a frequency synthesizer, the phase of the corresponding reference signals occurs between the two divider signals. In a preferred embodiment, two phase detectors (PD) are used each receiving the reference signal and one of the two divided VCO signals so that one phase detector can produce a voltage increase signal and the other phase detector can produce a voltage decrease signal in the locking stage.

A charge pump block can include N equal charge pump stages and can be coupled to one or both phase detector output terminals, and an output of each charge pump is combined in the sample-and-hold circuit. In the locking state, the amount of charging current and discharging current substantially compensate each other. Hence, no fractional ripple occurs. Thus, fractional compensation is dynamic and robust to the environmental changes such as circuit age, process and temperature in the preferred embodiments according to the present invention. Preferred embodiments of a frequency synthesizer can be implemented using a plurality of phase detectors with a sample-and-hold circuit to provide a uniform stable VCO control voltage.

**Claims**

1. A phase locked loop comprising: a first phase detector (314) that receives an input signal and a first divided signal (310) to output a first comparison signal (316,1014,1026, 1510); a second phase detector (324) that receives the input signal and a second divided signal (312) to output a second comparison signal (322, 1016, 1028, 1512); a circuit (328, 1536) that receives the first and second comparison signals and generates an output signal (328, 1534) responsive to the comparison signals; a voltage-controlled oscillator (330) that receives the output signal from the circuit and generates a prescribed frequency signal (332); and a programmable modulus divider (336) that receives the prescribed frequency signal and generates the first divided signal (310) and the second divided signal (312) by selectively dividing the prescribed frequency signal by one of a first value and a second value, the first and second divided signals having the same frequency, the phase locked loop being **characterised by** the first and second divided signal having a phase difference that is a period of the prescribed frequency signal from the voltage controlled oscillator.

2. The phase-locked loop of claim 1, further comprising a plurality of parallel switches (726, 728, 730, 732) operated by a control line, wherein each of the switches couple a corresponding one of a plurality of charge pumps (742, 744, 746, 748) to a selected one of the first and second comparison signals, depending on the position of said each switch.

3. The phase-locked loop of claim 2, wherein each of the charge pumps (742, 744, 746, 748) performs one of sourcing and sinking a prescribed amount of current to the circuit.

4. The phase-locked loop of claim 1, wherein the first phase detector comprises: a phase detector portion (PD1, PD2) with a first output port and a second output port; and a charge pump portion having a plurality of charge pump stages (742, 744, 746, 748).

5.  The phase-locked loop of claim 4, wherein each of the charge pump stages comprises:

a first current source (522) and a first switch (526) coupled in series between a first prescribed voltage and a charge pump output terminal (530);
a second current source (524) and a second switch (528) coupled in series between a second prescribed voltage and the charge pump output terminal (530);
a first logic gate (518) with a first input coupled to the first output port of the phase detector portion, a second input that receives a control signal and an output port coupled to the first switch (526); and
a second logic gate (520) with a first input coupled to the second output port of the phase detector portion, a second input that receives the control signal and an output port coupled to the second switch (528).

6.  The phase-locked loop of claim 5, wherein the first and second logic gates (518, 520) are AND gates, wherein an output of the first and second AND gates select one of the first and second switches (526, 528) to couple the charge pump output terminal (530) to one of the first and second current sources (522, 524).

7.  The phase-locked loop of claim 1, further comprising a signal delay device (1018) coupled to delay one of the first comparison signal and the second comparison signal output from the first and second phase detectors (314, 324), respectively.

8.  The phase-locked loop of claim 1, further comprising a signal delay device (1018) coupled to one of the first and second phase detectors (314, 324).

9.  The phase-locked loop of claim 8, wherein the signal delay device (1018) is one of a digital delay control circuit and an analog delay control circuit.

10. The phase-locked loop of claim 1, wherein the programmable modulus divider comprises:

a first logic gate (402);
a second logic (428) gate that receives a control signal;
a first flip-flop (412) coupled to receive an output signal of the first logic gate and a clock signal from the output port of the voltage-controlled oscillator;
a second flip-flop gate (420) coupled to receive an output signal of the first flip-flop, wherein the first and second logic gates receive an output signal of the second flip-flop; and
a third flip-flop (434) coupled to receive an output signal from the second logic gate (428), wherein the first, second and third flip-flops receive the prescribed frequency signal as a clock signal, wherein an output signal of the third flip-flop is received by the first logic gate (402), and wherein the output signals of the first and second flip-flops (412, 420) are the divided signals.

11. The phase-locked loop of claim 1, further comprising a detection circuit (1750) coupled to adjust a reference voltage in the circuit.

12. The phase-locked loop of claim 1, wherein the circuit is a sample-and-hold circuit (1536, 1740) that comprises:

a first switch (1518) and a first capacitor (1520) coupled at a first node (n1) in series between first and second prescribed reference voltages, wherein the first node is coupled to receive the first and second comparison signals (1510, 1512);
a second capacitor (1530) coupled between the second reference voltage and a second node (n2); and
a second switch (1524) coupled between the first and second nodes.

13. The phase-locked loop of claim 12, further comprising a detection circuit (1750) that sets the first prescribed reference voltage.

14. The phase-locked loop of claim 13, wherein the detection circuit comprises:

a lock detector (1718) that receives the comparison signals from the first and second phase detectors (314, 324); and

a digital-to-analog converter (1732) that adjusts a voltage level of the first prescribed reference voltage responsive to a control signal from the lock detector (1718).

15. The phase-locked loop of claim 13, wherein the detection circuit comprises:

an analog-to-digital converter (1820) that receives the output of the sample-and-hold circuit (1536,1740); and
a digital-to-analog converter (1830) that adjusts a voltage level of the first prescribed reference voltage responsive to a control signal from the analog-to-digital converter (1820).

16. The phase-locked loop of claim 13, wherein the detection circuit comprises:

a lock detector (1718) that receives the output signal from the sample-and-hold circuit (1740); and
a digital-to-analog converter (1830) that adjusts a voltage level of the first prescribed reference voltage responsive to a control signal from the lock detector (1718).

17. The phase-locked loop of claim 1, wherein the first phase detector (314) and the second phase detector (324) are of the same design.

18. The phase-locked loop of claim 1 further comprising:

an accumulator (340) having a first output port coupled to the second input port of the programmable modulus divider (336) and a second output port coupled to the third input ports of the phase detectors.

19. The phase-locked loop of claim 18, wherein the phase-locked loop is included in a mobile terminal and wherein the mobile terminal is one of a cellular phone, a personal digital assistant, a digital audio player, an Internet appliance, a remote control device or a laptop computer.

20. The phase-locked loop of claim 18, further comprising a plurality of switches (726, 728, 730, 732) operated by a control line, wherein each of the switches couple a corresponding one of a plurality of charge pumps (742, 744, 746, 748) to an output port of a selected one of the first phase detector (314) and the second phase detector (324) according to a control signal from the accumulator (340).

21. The phase-locked loop of claim 18, wherein the programmable modulus divider comprises;

a first logic gate (518);
a second logic gate (520) that receives a control signal;
a first flip-flop (412) coupled to receive an output signal of the first logic gate (518) and a clock signal from the output port of the voltage-controlled oscillator (330);
a second flip-flop gate (420) coupled to receive an output signal of the first flipflop (412), wherein the first and second logic gates receive an output signal of the second flip-flop (420); and
a third flip-flop (434) coupled to receive an output signal from the second logic gate (520), wherein the first, second and third flip-flops receive the prescribed frequency signal as a clock signal, wherein an output signal of the third flip-flop (434) is received by the first logic gate (518), and wherein the output signals of the first and second flip-flops (412, 420) correspond to the first and second divided signals (310, 312).

22. The phase-locked loop of claim 18, wherein the circuit includes a sample-and-hold circuit (1536, 1740) that comprises:

a first switch (1518) and a first capacitor (1520) coupled at a first node in series between first and second prescribed reference voltages, wherein the first node (n1) is coupled to receive a signal based on at least one of first and second comparison signals from the output ports of the phase detectors;
a second capacitor (1530) coupled between the second reference voltage and a second node (n2); and
a switch (1524) coupled between the first and second nodes.

23. The phase-locked loop of claim 22, further comprising a detection circuit (1750) that sets the first prescribed reference voltage.

24. The phase-locked loop of claim 23, wherein the detection circuit comprises:

a lock detector (1718) that receives the comparison signals from the first and second phase detectors; and
a digital-to-analog converter (1830) that adjusts a voltage level of the first prescribed reference voltage responsive to a control signal from the lock detector (1718).

**25.** The phase-locked loop of claim 24, wherein the detection circuit comprises:

an analog-to-digital converter (1820) that inputs an output signal of the sample-and-hold circuit; and
a digital-to-analog converter (1830) that adjusts a voltage level of the first prescribed reference voltage responsive to a control signal from the analog-to-digital converter (1820).

**26.** The phase-locked loop of claim 1, wherein the first value is an integer N and the second value N+1.

**27.** The phase-locked loop of claim 18, wherein the first phase detector (314) is coupled to a first number of charge pumps and the second detector (324) is coupled to a second number of charge pumps, and wherein the accumulator (340) controls a number of charge pumps to be enabled from the first and second number of charge pumps.

**28.** The phase-locked loop of claim 27, wherein the number of charge pumps to be enabled is controlled based on a state of the accumulator (340),

**29.** A method for generating frequency signals, comprising:

(a) dividing a frequency signal output from an oscillator to produce a first divided signal (310);
(b) dividing the frequency signal output from the oscillator to produce a second divided signal (312) not equal to the first divided signal, the first and second divided signals generated by selectively dividing the frequency signal by one of a first value and a second value, the first and second divided signals having the same frequency;
(c) comparing the phases of the first divided signal (310) and a reference signal to generate a first control signal (PD1, 1510);
(d) comparing the phases of the second divided signal (312) and a reference signal to generate a second control signal (PD2, 1512); and
(e) adjusting the oscillator based on the first control signal (PD1, 1510) and second control signal (PD2, 1512); the method being **characterised by** the first and second divided signals having a phase difference that is a period of the frequency signal output of the oscillator.

**30.** The method of claim 29, wherein the first control signal (PD1, 1510)increases a charge of a capacitor (1520) of a sample-and-hold circuit and the second control signal (PD2, 1512) decreases the charge of the capacitor (1520) of the sample-and-hold circuit; wherein the oscillator is adjusted based on an output of the sample-and-hold circuit.

**Patentansprüche**

**1.** Phasenregelkreis, der Folgendes umfasst:

einen ersten Phasendetektor (314), der ein Eingangssignal und ein erstes Teilsignal (310) empfängt und ein erstes Vergleichssignal (316, 1014, 1026, 1510) ausgibt,
einen zweiten Phasendetektor (324), der das Eingangssignal und ein zweites Teilsignal (312) empfängt und ein zweites Vergleichssignal (322, 1016, 1028, 1512) ausgibt,
eine Schaltung (328, 1536), die das erste und das zweite Vergleichssignal empfängt und als Reaktion auf die Vergleichssignale ein Ausgangssignal (328, 1534) erzeugt,
einen spannungsgesteuerten Oszillator (330), der das Ausgangssignal von der Schaltung empfängt und ein vorgegebenes Frequenzsignal (332) erzeugt, und
einen programmierbaren Betragteiler (336), der das vorgegebene Frequenzsignal empfängt und das erste Teilsignal (310) sowie das zweite Teilsignal (312) erzeugt, indem er das vorgegebene Frequenzsignal selektiv durch einen ersten oder einen zweiten Wert teilt, wobei das erste und das zweite Teilsignal die gleiche Frequenz aufweisen,

wobei der Phasenregelkreis **dadurch gekennzeichnet ist, dass** das erste und das zweite Teilsignal eine Phasendifferenz aufweisen, bei der es sich um eine Periode des vorgegebenen Frequenzsignals aus dem spannungsgesteuerten Oszillator handelt.

2. Phasenregelkreis nach Anspruch 1, der des Weiteren mehrere parallele Schalter (726, 728, 730, 732) umfasst, die von einer Steuerleitung betätigt werden, wobei jeder Schalter eine entsprechende Ladungspumpe von mehreren Ladungspumpen (742, 744, 746, 748) in Abhängigkeit von der Position des jeweiligen Schalters mit dem gewählten ersten oder zweiten Vergleichssignal koppelt.

3. Phasenregelkreis nach Anspruch 2, bei dem jede der Ladungspumpen (742, 744, 746, 748) für die Schaltung einen vorgegebenen Strombetrag liefert oder verbraucht.

4. Phasenregelkreis nach Anspruch 1, bei dem der erste Phasendetektor Folgendes umfasst:

    einen Phasendetektorabschnitt (PD1, PD2) mit einem ersten und einem zweiten Ausgangsanschluss und einen Ladungspumpenabschnitt mit mehreren Ladungspumpstufen (742, 744, 746, 748).

5. Phasenregelkreis nach Anspruch 4, bei dem jede der Ladungspumpstufen Folgendes umfasst:

    eine erste Stromquelle (522) und einen ersten Schalter (526), die in Reihe zwischen eine erste vorgegebene Spannung und einen Ladungspumpen-Ausgangsanschluss (530) geschaltet sind,
    eine zweite Stromquelle (524) und einen zweiten Schalter (528), die in Reihe zwischen eine zweite vorgegebene Spannung und den Ladungspumpen-Ausgangsanschluss (530) geschaltet sind,
    ein erstes Logikgatter (518) mit einem ersten Eingang, der an den ersten Ausgangsanschluss des Phasendetektorabschnittes gekoppelt ist, einem zweiten Eingang, der ein Steuersignal empfängt, und einem Ausgangsanschluss, der an den ersten Schalter (526) gekoppelt ist, und
    ein zweites Logikgatter (520) mit einem ersten Eingang, der an den zweiten Ausgangsanschluss des Phasendetektorabschnittes gekoppelt ist, einem zweiten Eingang, der das Steuersignal empfängt, und einem Ausgangsanschluss, der an den zweiten Schalter (528) gekoppelt ist.

6. Phasenregelkreis nach Anspruch 5, bei dem es sich bei dem ersten und dem zweiten Logikgatter (518, 520) um UND-Gatter handelt, wobei ein Ausgangswert des ersten und des zweiten UND-Gatters den ersten oder den zweiten Schalter (526, 528) auswählt, um den Ladungspumpen-Ausgangsanschluss (530) an die erste oder die zweite Stromquelle (522, 524) zu koppeln.

7. Phasenregelkreis nach Anspruch 1, der des Weiteren eine Signalverzögerungseinrichtung (1018) umfasst, die angekoppelt ist, um das erste oder das zweite Vergleichssignal, das von dem ersten beziehungsweise dem zweiten Phasendetektor (314, 324) ausgegeben wird, zu verzögern.

8. Phasenregelkreis nach Anspruch 1, der des Weiteren eine Signalverzögerungseinrichtung (1018) umfasst, die an den ersten oder den zweiten Phasendetektor (314, 324) gekoppelt ist.

9. Phasenregelkreis nach Anspruch 8, bei dem es sich bei der Signalverzögerungseinrichtung (1018) um eine digitale oder eine analoge Verzögerungssteuerschaltung handelt.

10. Phasenregelkreis nach Anspruch 1, bei dem der programmierbare Betragteiler Folgendes umfasst:

    ein erstes Logikgatter (402),
    ein zweites Logikgatter (428), das ein Steuersignal empfängt,
    ein erstes Flipflop (412), das so angekoppelt ist, dass es ein Ausgangssignal von dem ersten Logikgatter und ein Taktsignal aus dem Ausgangsanschluss des spannungsgesteuerten Oszillators empfängt,
    ein zweites Flipflop (420), das so angekoppelt ist, dass es ein Ausgangssignal von dem ersten Flipflop empfängt, wobei das erste und das zweite Logikgatter ein Ausgangssignal von dem zweiten Flipflop empfangen, und
    ein drittes Flipflop (434), das so angekoppelt ist, dass es ein Ausgangssignal von dem zweiten Logikgatter (428) empfängt, wobei das erste, das zweite und das dritte Flipflop das vorgegebene Frequenzsignal als Taktsignal empfangen, ein Ausgangssignal des dritten Flipflops von dem ersten Logikgatter (402) empfangen wird und es sich bei den Ausgangssignalen des ersten und des zweiten Flipflops (412, 420) um die Teilsignale handelt.

11. Phasenregelkreis nach Anspruch 1, der des Weiteren eine Erfassungsschaltung (1750) umfasst, die angekoppelt ist, um eine Bezugsspannung in der Schaltung zu regulieren.

12. Phasenregelkreis nach Anspruch 1, bei dem es sich bei der Schaltung um eine Abtast-Halte-Schaltung (1536, 1740) handelt, die Folgendes umfasst:

einen ersten Schalter (1518) und einen ersten Kondensator (1520), die an einem ersten Knoten (n1) in Reihe zwischen eine erste und eine zweite vorgegebene Bezugsspannung geschaltet sind, wobei der erste Knoten so angekoppelt ist, dass er das erste und das zweite Vergleichssignal (1510, 1512) empfängt.
einen zweiten Kondensator (1530), der zwischen die zweite Bezugsspannung und einen zweiten Knoten (n2) gekoppelt ist, und
einen zweiten Schalter (1524), der zwischen den ersten und den zweiten Knoten gekoppelt ist.

**13.** Phasenregelkreis nach Anspruch 12, der des Weiteren eine Erfassungsschaltung (1750) umfasst, die die erste vorgegebene Bezugsspannung einstellt.

**14.** Phasenregelkreis nach Anspruch 13, bei dem die Erfassungsschaltung Folgendes umfasst:

einen Einrastdetektor (1718), der die Vergleichssignale von dem ersten und dem zweiten Phasendetektor (314, 324) empfängt, und
einen Digital-Analog-Wandler (1732), der als Reaktion auf ein Steuersignal von dem Einrastdetektor (1718) einen Spannungspegel der ersten vorgegebenen Bezugsspannung reguliert.

**15.** Phasenregelkreis nach Anspruch 13, bei dem die Erfassungsschaltung Folgendes umfasst:

einen Analog-Digital-Wandler (1820), der den Ausgangswert von der Abtast-Halte-Schaltung (1536, 1740) empfängt, und
einen Digital-Analog-Wandler (1830), der als Reaktion auf ein Steuersignal von dem Analog-Digital-Wandler (1820) einen Spannungspegel der ersten vorgegebenen Bezugsspannung reguliert.

**16.** Phasenregelkreis nach Anspruch 13, bei dem die Erfassungsschaltung Folgendes umfasst:

einen Einrastdetektor (1718), der das Ausgangssignal von der Abtast-Halte-Schaltung (1740) empfängt, und
einen Digital-Analog-Wandler (1830), der als Reaktion auf ein Steuersignal von dem Einrastdetektor (1718) einen Spannungspegel der ersten vorgegebenen Bezugsspannung reguliert.

**17.** Phasenregelkreis nach Anspruch 1, bei dem der erste Phasendetektor (314) und der zweite Phasendetektor (324) den gleichen Aufbau aufweisen.

**18.** Phasenregelkreis nach Anspruch 1, der des Weiteren Folgendes umfasst:

einen Akkumulator (340), bei dem ein erster Ausgangsanschluss an den zweiten Eingangsanschluss des programmierbaren Betragteilers (336) und ein zweiter Ausgangsanschluss an die dritten Eingangsanschlüsse der Phasendetektoren gekoppelt ist.

**19.** Phasenregelkreis nach Anspruch 18, wobei sich der Phasenregelkreis in einem mobilen Endgerät befindet und es sich bei dem mobilen Endgerät um ein Mobiltelefon, einen elektronischen Assistenten (PDA), ein digitales Audiowiedergabegerät, eine Internet-Vorrichtung, eine Fernbedienung oder einen Laptop handelt.

**20.** Phasenregelkreis nach Anspruch 18, der des Weiteren mehrere Schalter (726, 728, 730, 732) umfasst, die von einer Steuerleitung betätigt werden, wobei jeder Schalter eine entsprechende Ladungspumpe von mehreren Ladungspumpen (742, 744, 746, 748) einem Steuersignal von dem Akkumulator (340) entsprechend an einen Ausgangsanschluss des gewählten ersten Phasendetektors (314) oder zweiten Phasendetektors (324) koppelt.

**21.** Phasenregelkreis nach Anspruch 18, bei dem der programmierbare Betragteiler Folgendes umfasst:

ein erstes Logikgatter (518),
ein zweites Logikgatter (520), das ein Steuersignal empfängt,
ein erstes Flipflop (412), das so angekoppelt ist, dass es ein Ausgangssignal von dem ersten Logikgatter (518) und ein Taktsignal aus dem Ausgangsanschluss des spannungsgesteuerten Oszillators (330) empfängt,
ein zweites Flipflop (420), das so angekoppelt ist, dass es ein Ausgangssignal von dem ersten Flipflop (412) empfängt, wobei das erste und das zweite Logikgatter ein Ausgangssignal von dem zweiten Flipflop (420) empfangen, und

ein drittes Flipflop (434), das so angekoppelt ist, dass es ein Ausgangssignal von dem zweiten Logikgatter (520) empfängt, wobei das erste, das zweite und das dritte Flipflop das vorgegebene Frequenzsignal als Taktsignal empfangen, ein Ausgangssignal des dritten Flipflops (434) von dem ersten Logikgatter (518) empfangen wird und die Ausgangssignale des ersten und des zweiten Flipflops (412, 420) dem ersten und dem zweiten Teilsignal (310, 312) entsprechen.

22. Phasenregelkreis nach Anspruch 18, bei dem die Schaltung eine Abtast-Halte-Schaltung (1536, 1740) enthält, die Folgendes umfasst:

einen ersten Schalter (1518) und einen ersten Kondensator (1520), die an einem ersten Knoten in Reihe zwischen eine erste und eine zweite vorgegebene Bezugsspannung geschaltet sind, wobei der erste Knoten (n1) so angekoppelt ist, dass er ein Signal empfängt, das mindestens auf dem ersten oder dem zweiten Vergleichssignal von den Ausgangsanschlüssen der Phasendetektoren basiert, einen zweiten Kondensator (1530), der zwischen die zweite Bezugsspannung und einen zweiten Knoten (n2) gekoppelt ist, und einen Schalter (1524), der zwischen den ersten und den zweiten Knoten gekoppelt ist.

23. Phasenregelkreis nach Anspruch 22, der des Weiteren eine Erfassungsschaltung (1750) umfasst, die die erste vorgegebene Bezugsspannung einstellt.

24. Phasenregelkreis nach Anspruch 23, bei dem die Erfassungsschaltung Folgendes umfasst:

einen Einrastdetektor (1718), der die Vergleichssignale von dem ersten und dem zweiten Phasendetektor empfängt, und einen Digital-Analog-Wandler (1830), der als Reaktion auf ein Steuersignal von dem Einrastdetektor (1718) einen Spannungspegel der ersten vorgegebenen Bezugsspannung reguliert.

25. Phasenregelkreis nach Anspruch 24, bei dem die Erfassungsschaltung Folgendes umfasst:

einen Analog-Digital-Wandler (1820), der ein Ausgangssignal von der Abtast-Halte-Schaltung eingibt, und einen Digital-Analog-Wandler (1830), der als Reaktion auf ein Steuersignal von dem Analog-Digital-Wandler (1820) einen Spannungspegel der ersten vorgegebenen Bezugsspannung reguliert.

26. Phasenregelkreis nach Anspruch 1, bei dem es sich bei dem ersten Wert um eine ganze Zahl N und bei dem zweiten Wert um N+1 handelt.

27. Phasenregelkreis nach Anspruch 18, bei dem der erste Phasendetektor (314) an eine erste Anzahl Ladungspumpen und der zweite Detektor (324) an eine zweite Anzahl Ladungspumpen gekoppelt ist und der Akkumulator (340) aus der ersten und der zweiten Anzahl Ladungspumpen eine Anzahl Ladungspumpen steuert, die aktiviert werden sollen.

28. Phasenregelkreis nach Anspruch 27, bei dem die Anzahl der zu aktivierenden Ladungspumpen auf der Grundlage eines Zustandes des Akkumulators (340) gesteuert wird.

29. Verfahren für das Erzeugen von Frequenzsignalen, das Folgendes umfasst:

(a) Teilen eines von einem Oszillator ausgegebenen Frequenzsignals, um ein erstes Teilsignal (310) zu erzeugen,
(b) Teilen des von dem Oszillator ausgegebenen Frequenzsignals, um ein zweites Teilsignal (312) zu erzeugen, das ungleich dem ersten Teilsignal ist, wobei das erste und das zweite Teilsignal über ein selektives Teilen des Frequenzsignals durch einen ersten oder einen zweiten Wert erzeugt werden und die gleiche Frequenz aufweisen,
(c) Vergleichen der Phasen des ersten Teilsignals (310) und eines Bezugssignals, um ein erstes Steuersignal (PD1, 1510) zu erzeugen,
(d) Vergleichen der Phasen des zweiten Teilsignals (312) und eines Bezugssignals, um ein zweites Steuersignal (PD2, 1512) zu erzeugen, und
(e) Regeln des Oszillators auf der Grundlage des ersten Steuersignals (PD1, 1510) und des zweiten Steuersignals (PD2, 1512),

wobei das Verfahren **dadurch gekennzeichnet ist, dass** das erste und das zweite Teilsignal eine Phasendifferenz aufweisen, bei der es sich um eine Periode des von dem Oszillator ausgegebenen Frequenzsignals handelt.

30. Verfahren nach Anspruch 29, bei dem das erste Steuersignal (PD1, 1510) die Ladung eines Kondensators (1520) einer Abtast-Halte-Schaltung erhöht und das zweite Steuersignal (PD2, 1512) die Ladung des Kondensators (1520) der Abtast-Halte-Schaltung verringert, wobei der Oszillator auf der Grundlage eines Ausgangswertes der Abtast-Halte-Schaltung reguliert wird.

**Revendications**

1. Boucle à phase asservie comprenant : un premier détecteur de phase (314) qui reçoit un signal d'entrée et un premier signal divisé (310) pour fournir un premier signal de comparaison (316, 1014, 1026, 1510); un deuxième détecteur de phase (324) qui reçoit le signal d'entrée et un deuxième signal divisé (312) pour fournir un deuxième signal de comparaison (322, 1016, 1028, 1512); un circuit (328, 1536) qui reçoit les premier et deuxième signaux de comparaison et génère un signal de sortie (328, 1534) en réponse aux signaux de comparaison; un oscillateur commandé par tension (330) qui reçoit le signal de sortie du circuit et génère un signal de fréquence prescrite (332); et un diviseur de module programmable (336) qui reçoit le signal de fréquence prescrite et génère le premier signal divisé (310) et le deuxième signal divisé (312) en divisant sélectivement le signal de fréquence prescrite par l'une d'une première valeur et d'une deuxième valeur, les premier et deuxième signaux divisés ayant la même fréquence, la boucle à phase asservie étant **caractérisée par le fait que** les premier et deuxième signaux divisés ont une différence de phase qui est une période du signal de fréquence prescrite provenant de l'oscillateur commandé par tension.

2. Boucle à phase asservie selon la revendication 1, comprenant en outre une pluralité de commutateurs parallèles (726, 728, 730, 732) actionnés par une ligne de commande, dans laquelle chacun des commutateurs couple une pompe à charge correspondante d'une pluralité de pompes à charge (742, 744, 746, 748) au signal sélectionné des premier et deuxième signaux de comparaison, selon la position dudit commutateur.

3. Boucle à phase asservie selon la revendication 2, dans laquelle chacune des pompes à charge (742, 744, 746, 748) fournit au circuit une quantité prescrite de courant de source ou de puits.

4. Boucle à phase asservie selon la revendication 1, dans laquelle le premier détecteur de phase comprend : une partie détecteur de phase (PD1, PD2) ayant un premier port de sortie et un deuxième port de sortie; et une partie pompe à charge ayant une pluralité d'étages de pompe à charge (742, 744, 746, 748).

5. Boucle à phase asservie selon la revendication 4, dans laquelle chacun des étages de pompe à charge comprend :

   une première source de courant (522) et un premier commutateur (526) couplés en série entre une première tension prescrite et une borne de sortie de pompe à charge (530);
   une deuxième source de courant (524) et un deuxième commutateur (528) couplés en série entre une deuxième tension prescrite et la borne de sortie de pompe à charge (530);
   une première porte logique (518) ayant une première entrée couplée au premier port de sortie de la partie détecteur de phase, une deuxième entrée qui reçoit un signal de commande et un port de sortie couplé au premier commutateur (526); et
   une deuxième porte logique (520) ayant une première entrée couplée au deuxième port de sortie de la partie détecteur de phase, une deuxième entrée qui reçoit le signal de commande et un port de sortie couplé au deuxième commutateur (528).

6. Boucle à phase asservie selon la revendication 5, dans laquelle les première et deuxième portes logiques (518, 520) sont des portes ET, dans laquelle une sortie des première et deuxième portes ET sélectionne l'un du premier et du deuxième commutateurs (526, 528) pour coupler la borne de sortie de pompe à charge (530) à l'une des première et deuxième sources de courant (522, 524).

7. Boucle à phase asservie selon la revendication 1, comprenant en outre un dispositif de temporisation de signal (1018) couplé pour temporiser la sortie du premier signal de comparaison ou du deuxième signal de comparaison provenant des premier et deuxième détecteurs de phase (314, 324), respectivement.

**8.** Boucle à phase asservie selon la revendication 1, comprenant en outre un dispositif de temporisation de signal (1018) couplé à l'un des premier et deuxième détecteurs de phase (314, 324).

**9.** Boucle à phase asservie selon la revendication 8, dans laquelle le dispositif de temporisation de signal (1018) est soit un circuit de commande de temporisation numérique soit un circuit de commande de temporisation analogique.

**10.** Boucle à phase asservie selon la revendication 1, dans laquelle le diviseur de module programmable comprend :

une première porte logique (402);
une deuxième porte logique (428) qui reçoit un signal de commande;
une première bascule bistable (412) couplée pour recevoir un signal de sortie de la première porte logique et un signal d'horloge du port de sortie de l'oscillateur commandé par tension;
une deuxième porte à bascule bistable (420) couplée pour recevoir un signal sortie de la première bascule bistable, dans laquelle les première et deuxième portes logiques reçoivent un signal de sortie de la deuxième bascule bistable; et
une troisième bascule bistable (434) couplée pour recevoir un signal de sortie de la deuxième porte logique (428), dans laquelle les première, deuxième et troisième bascules bistables reçoivent le signal de fréquence prescrite en tant que signal d'horloge, dans laquelle un signal de sortie de la troisième bascule bistable est reçu par la première porte logique (402), et dans laquelle les signaux de sortie des première et deuxième bascules bistables (412, 420) sont les signaux divisés.

**11.** Boucle à phase asservie selon la revendication 1, comprenant en outre un circuit de détection (1750) couplé pour ajuster une tension de référence dans le circuit.

**12.** Boucle à phase asservie selon la revendication 1, dans laquelle le circuit est un circuit échantillonneur-bloqueur (1536, 1740) qui comprend :

un premier commutateur (1518) et un premier condensateur (1520) couplés à un premier noeud (n1) en série entre les première et deuxième tensions de référence prescrites, dans lequel le premier noeud est couplé pour recevoir les premier et deuxième signaux de comparaison (1510, 1512);
un deuxième condensateur (1530) couplé entre la deuxième tension de référence et un deuxième noeud (n2); et
un deuxième commutateur (1524) couplé entre les premier et deuxième noeuds.

**13.** Boucle à phase asservie selon la revendication 12, comprenant en outre un circuit de détection (1750) qui fixe la première tension de référence prescrite.

**14.** Boucle à phase asservie selon la revendication 13, dans laquelle le circuit de détection comprend :

un détecteur de blocage (1718) qui reçoit les signaux de comparaison des premier et deuxième détecteurs de phase (314, 324); et
un convertisseur numérique-analogique (1732) qui ajuste un niveau de tension de la première tension de référence prescrite en réponse à un signal de commande émis par le détecteur de blocage (1718).

**15.** Boucle à phase asservie selon la revendication 13, dans laquelle le circuit de détection comprend :

un convertisseur analogique-numérique (1820) qui reçoit la sortie du circuit échantillonneur-bloqueur (1536, 1740); et
un convertisseur numérique-analogique (1830) qui ajuste un niveau de tension de la première tension de référence prescrite en réponse à un signal de commande émis par le convertisseur analogique-numérique (1820).

**16.** Boucle à phase asservie selon la revendication 13, dans laquelle le circuit de détection comprend :

un détecteur de blocage (1718) qui reçoit le signal de sortie du circuit échantillonneur-bloqueur (1740); et
un convertisseur numérique-analogique (1830) qui ajuste le niveau de tension de la première tension de référence prescrite en réponse à un signal de commande émis par le détecteur de blocage (1718).

**17.** Boucle à phase asservie selon la revendication 1, dans laquelle le premier détecteur de phase (314) et le deuxième détecteur de phase (324) sont de même conception.

**18.** Boucle à phase asservie selon la revendication 1, comprenant en outre :

un accumulateur (340) ayant un premier port de sortie couplé au deuxième port d'entrée du diviseur de module programmable (336) et un deuxième port de sortie couplé aux troisièmes ports d'entrée des détecteurs de phase.

**19.** Boucle à phase asservie selon la revendication 18, ladite boucle à phase asservie étant incluse dans un terminal mobile et le terminal mobile étant soit un téléphone cellulaire, soit un assistant numérique personnel, soit un lecteur audio numérique, soit un appareil Internet, soit un dispositif de télécommande, soit un ordinateur portable.

**20.** Boucle à phase asservie selon la revendication 18, comprenant en outre une pluralité de commutateurs (726, 728, 730, 732) actionnés par une ligne de commande, dans laquelle chacun des commutateurs couple une pompe à charge correspondante d'une pluralité de pompes à charge (742, 744, 746, 748) à un port de sortie d'un détecteur sélectionné entre le premier détecteur de phase (314) et le deuxième détecteur de phase (324) selon un signal de commande émis par l'accumulateur (340).

**21.** Boucle à phase asservie selon la revendication 18, dans laquelle le diviseur de module programmable comprend :

une première porte logique (518);
une deuxième porte logique (520) qui reçoit un signal de commande ;
une première bascule bistable (412) couplée pour recevoir un signal de sortie de la première porte logique (518) et un signal d'horloge du port de sortie de l'oscillateur commandé par tension (330) ;
une deuxième porte à bascule bistable (420) couplée pour recevoir un signal de sortie de la première bascule bistable (412), dans laquelle les première et deuxième portes logiques reçoivent un signal d'entrée de la deuxième bascule bistable (420) ; et
une troisième bascule bistable (434) couplée pour recevoir un signal de sortie de la deuxième porte logique (520), dans laquelle les première, deuxième et troisième bascules bistables reçoivent le signal de fréquence prescrite en tant que signal d'horloge, dans laquelle un signal de sortie de la troisième bascule bistable (434) est reçu par la première porte logique (518), et dans laquelle les signaux de sortie des première et deuxième bascules bistables (412, 420) correspondent aux premier et deuxième signaux divisés (310, 312).

**22.** Boucle à phase asservie selon la revendication 18, dans laquelle le circuit comprend un circuit échantillonneur-bloqueur (1536, 1740) constitué de :

un premier commutateur (1518) et un premier condensateur (1520) couplés à un premier noeud en série entre des première et deuxième tensions de référence prescrites, dans lequel le premier noeud (n1) est couplé pour recevoir un signal basé sur au moins l'un d'un premier et d'un deuxième signaux de comparaison provenant des ports de sortie des détecteurs de phase ;
un deuxième condensateur (1530) couplé entre la deuxième tension de référence et un deuxième noeud (n2) ; et
un commutateur (1524) couplé entre les premier et deuxième noeuds.

**23.** Boucle à phase asservie selon la revendication 22, comprenant en outre un circuit de détection (1750) qui fixe la première tension de référence prescrite.

**24.** Boucle à phase asservie selon la revendication 23, dans laquelle le circuit de détection comprend :

un détecteur de blocage (1718) qui reçoit les signaux de comparaison des premier et deuxième détecteurs de phase ; et
un convertisseur numérique-analogique (1830) qui ajuste un niveau de tension de la première tension de référence prescrite en réponse à un signal de commande provenant du détecteur de blocage (1718).

**25.** Boucle à phase asservie selon la revendication 24, dans laquelle le circuit de détection comprend :

un convertisseur analogique-numérique (1820) qui fournit un signal de sortie du circuit échantillonneur-bloqueur ; et
un convertisseur numérique-analogique (1830) qui ajuste un niveau de tension de la première tension de référence prescrite en réponse à un signal de commande provenant du convertisseur analogique-numérique (1820).

26. Boucle à phase asservie selon la revendication 1, dans laquelle la première valeur est un nombre entier N et la deuxième valeur N+1.

27. Boucle à phase asservie selon la revendication 18, dans laquelle le premier détecteur de phase (314) est couplé à un premier nombre de pompes à charge et le deuxième détecteur (324) est couplé à un deuxième nombre de pompes à charge, et dans laquelle l'accumulateur (340) commande un certain nombre de pompes à charge devant être activées parmi les premier et deuxième nombres de pompes à charge.

28. Boucle à phase asservie selon la revendication 27, dans laquelle le nombre de pompes à charge à activer est commandé en fonction de l'état de l'accumulateur (340).

29. Procédé pour générer des signaux de fréquence, comprenant :

(a) la division d'une sortie de signal de fréquence d'un oscillateur pour produire un premier signal divisé (310) ;
(b) la division de la sortie de signal de fréquence de l'oscillateur pour produire un deuxième signal divisé (312) qui n'est pas égal au premier signal divisé, les premier et deuxième signaux divisés étant générés par division sélective du signal de fréquence par l'une d'une première valeur et d'une deuxième valeur, les premier et deuxième signaux divisés ayant la même fréquence ;
(c) la comparaison des phases du premier signal divisé (310) et d'un signal de référence pour générer un premier signal de commande (PD1, 1510) ;
(d) la comparaison des phases du deuxième signal divisé (312) et d'un signal de référence pour générer un deuxième signal de commande (PD2, 1512) ; et
(e) le réglage de l'oscillateur en fonction du premier signal de commande (PD1, 1510) et du deuxième signal de commande (PD2, 1512) ;

le procédé étant **caractérisé par le fait que** les premier et deuxième signaux divisés ont une différence de phase qui est une période de la sortie de signal de fréquence de l'oscillateur.

30. Procédé selon la revendication 29, dans lequel le premier signal de commande (PD1, 1510) augmente la charge d'un condensateur (1520) d'un circuit échantillonneur-bloqueur et le deuxième signal de commande (PD2, 1512) diminue la charge du condensateur (1520) du circuit échantillonneur-bloqueur ; dans lequel l'oscillateur est réglé en fonction d'une sortie du circuit échantillonneur-bloqueur.

FIG. 1

EP 1 371 167 B1

FIG. 2(a)

FIG. 2(b)

Reference

Divider
Output

PD
Output

Vhold
Vsample Vref

T

EP 1 371 167 B1

Reference

Divider Output

PD Output

Vhold Vsample

Vref

$T$

$T1-(3/8)-T_{VCO}$

$T1-(6/8)-T_{VCO}$

$T1-(1/8)-T_{VCO}$

Fractional Accumulator State

0

3

6

1

FIG. 2(c)

FIG. 3

EP 1 371 167 B1

FIG. 4

400

404

406

402

408

Fout
436

412
FF

414

FDIV1

416

420
FF

422

FDIV2

426
Modulus Control

428

430

434
FF

FIG. 5

EP 1 371 167 B1

| | | | | |
|---|---|---|---|---|
| References | | | | ⌇~602 |
| Divider Output1 | | | | ⌇~604 |
| Divider Output2 | | | | ⌇~606 |
| Number of CP1 enabled Number of CP2 enabled | (8 0) | (5 3) | (2 6) | (7 1) | ←—608 |
| Fractional Accumulator State | 0 | 3 | 6 | 1 | ←—610 |
| Divider State | 8(N) | 8(N) | 8(N) | 9(N+1) | ←—612 |

## FIG. 6

FIG. 7

EP 1 371 167 B1

FIG. 8(a)

EP 1 371 167 B1

FIG. 8(b)

FIG. 9

EP 1 371 167 B1

FIG. 10

FIG. 11

EP 1 371 167 B1

FIG. 12

EP 1 371 167 B1

1300

1338
1336
1334
1332

1340

IN

1302

1304 1312 1320 1328

OUT

1350
CONTROL

## FIG. 13

1400

1404 1412 1416 1424
1426

IN

1402

OUT

1428
CONTROL

## FIG. 14

FIG. 15

FIG. 16

EP 1 371 167 B1

FIG. 17

EP 1 371 167 B1

FIG. 18

EP 1 371 167 B1

Reference ⌐1902

Divider
Output1 ⌐1904
Tvco ⌐1906

Divider
Output2

⌐1908

PD1 Output

(3/8)=Tvco (6/8)=Tvco (2/8)=Tvco
(5/8)=Tvco (1/8)=Tvco

Number of
CP enabled  8    5    2    ←1912

PD2 Output ⌐1910

Number of
CP enabled  0    3    6    1    ←1916

Vhold=Vref ⌐1918
Vsample

Fractional
Accumulator   0      3      6      1    ←1914
State

FIG. 19

EP 1 371 167 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6137372 A
- EP 0907252 A